# EUROPEAN PATENT APPLICATION

(11) **EP 4 737 790 A1**
(43) Date of publication of application: **06.05.2026**
(21) Application number: 24832528.4
(22) Date of filing: 28.06.2024
(51) Int. Cl.: F21K 9/238, F21V 23/00, F21V 29/74, H10H 20/857, F21Y 115/10

(54) **LIGHTING DEVICE AND LAMP**

(30) Priority: 29.06.2023 KR 20230084540
(71) Applicant: LG INNOTEK CO. LTD, Gangseo-gu Seoul 07796 (KR)
(72) Inventor: LEE, Jung Ho, Seoul 07796 (KR); LEE, Hee Jung, Seoul 07796 (KR); KIM, Won Jin, Seoul 07796 (KR)
(74) Representative: Plasseraud IP
(86) International application number: PCT/KR2024/009150
(87) International publication number: WO 2025/005752

(57) **Abstract**

A lighting device disclosed in an embodiment of the invention comprises: a support plate having a concave receiving portion on an upper portion; a circuit board disposed on the receiving portion of the support plate; a plurality of pads disposed on one side of the circuit board; a light source portion disposed on the support plate and having a light emitting device and a plurality of bonding pads; a plurality of connection members respectively connecting the plurality of pads to the plurality of bonding pads; and a molding portion covering the plurality of connection members, the plurality of pads, and the plurality of bonding pads, wherein an outer line of the molding portion has first to fourth side portions, the first side portion of the molding portion extends in a first direction along a region between an upper surface of the light emitting device and an upper surface of the plurality of bonding pads on the light source portion, a second side portion of the molding portion extends in the first direction along an outer side of the plurality of pads on the circuit board, and a third side portion and a fourth side portion of the molding portion extend in a second direction orthogonal to the first direction from both ends of the first and second side portions, and may include a convex curve and a concave curve.

## Description

### [Technical Field]

An embodiment of the invention relates to a lighting device and a lamp.

### [Background Art]

Lighting applications include vehicle lights as well as backlights for displays and signs. Light emitting device, such as light emitting diode (LED), have advantages such as low power consumption, semi-permanent life, fast response speed, safety, and environmental friendliness compared to conventional light sources such as fluorescent lamps and incandescent lamps. These light emitting diodes are applied to various display devices, various lighting devices such as indoor or outdoor lights. Recently, as a vehicle light source, a lamp employing a light emitting diode has been proposed. Compared with incandescent lamps, light emitting diodes are advantageous in that power consumption is small. However, since an emission angle of light emitted from the light emitting diode is small, when the light emitting diode is used as a vehicle lamp, there is a demand for increasing the light emitting area of the lamp using the light emitting diode.

### [Disclosure]

### [Technical Problem]

An embodiment of the invention provides a lighting module and a lighting device having a member that secures at least a portion of a connection member that electrically connects a light source portion and a circuit board. An embodiment of the invention provides a lighting module and a lighting device having a member that secures a portion or all of a plurality of connection members that electrically connects a light source portion and a circuit board. An embodiment of the invention provides a lighting module and a lighting device having a member that secures a position of a portion of one or a plurality of wires on at least one region of an upper surface of a circuit board or an upper surface of a support plate. An embodiment of the invention provides a lighting device and a lamp or an automobile lamp having the same.

### [Technical Solution]

The lighting device according to an embodiment of an invention comprises: a support plate having a concave receiving portion on an upper portion thereof; a circuit board disposed on the receiving portion of the support plate; a plurality of pads disposed on one side of the circuit board; a light source portion disposed on the support plate and having a light emitting device and a plurality of bonding pads; a plurality of connection members respectively connecting the plurality of pads to the plurality of bonding pads; and a molding portion covering the plurality of connection members, the plurality of pads, and the plurality of bonding pads, wherein an outer line of the molding portion has first to fourth side portions, the first side portion of the molding portion extends in a first direction along a region between an upper surface of the light emitting device and an upper surface of the plurality of bonding pads on the light source portion, a second side portion of the molding portion extends in the first direction along an outer side of the plurality of pads on the circuit board, and a third side portion and the fourth side portion of the molding portion extend in a second direction orthogonal to the first direction from both ends of the first and second sides, and may include a convex curve and a concave curve.

According to an embodiment of the invention, the plurality of pads include a first pad and a second pad adjacent to the light source portion, the plurality of bonding pads include a first bonding pad and a second bonding pad adjacent to the circuit board, the plurality of connection members include a first connection member connecting the first pad and the first bonding pad, and a second connection member connecting the second pad and the second bonding pad, and the uppermost end of the molding portion may be positioned higher than the highest points of the first and second connection members based on the upper surface of the circuit board.

According to an embodiment of the invention, the highest point of the molding portion may be positioned on a region between the circuit board and the light source portion. The highest points of the first and second connection members may be positioned on a region between the circuit board and the light source portion. The the invention includes an adhesive member disposed between the light source portion and the support plate, and third and fourth side portions of the molding portion may protrude further outward than the adhesive member disposed on both sides of the light source portion in the first direction.

According to an embodiment of the invention, the first side portion of the molding portion may have a linear shape or a concave shape along the plurality of bonding pads on the light source portion. One side region of the third side portion and one side region of the fourth side portion may have convex curved regions on both sides of the light source portion. A distance between the first side portion of the molding portion and the light emitting device may gradually increase from both sides of the light source portion in the first direction toward the region between the plurality of bonding pads.

According to an embodiment of the invention, the first and second connection members each include a first end bonded to the first and second bonding pads, a second end bonded to the first and second pads, and an intermediate wire portion connecting the first and second end portions, wherein a distance between the second ends of the first and second connection members may be greater than a distance between the first ends of the first and second connection members. Each of the plurality of connection members may be a ribbon-shaped wire having a width greater than twice a thickness thereof.

A lamp according to an embodiment of the invention comprises a lighting device emitting white light; and a light guide module or reflector on the lighting device, wherein the lighting device may include the lighting device disclosed above.

### [Advantageous Effects]

An embodiment of the invention can improve electrical reliability due to the connection member by supporting and fixing a portion or all of a connection member connecting between a light source portion and a circuit board, thereby preventing deformation of the connection member and preventing cracks in the connection member. An Embodiment of the invention mold a portion or all of the connection member connecting the light source portion and the circuit board with a molding portion, thereby preventing the connection member from moving and blocking electrical contact between the connection members, and openings or cracks that may occur in the bonding portion between the connection member and the pad may be suppressed. An embodiment of the invention can improve the reliability of a lighting module and a lighting device including the same.

### [Description of Drawings]

FIG. 1a is a perspective view of a lighting device according to the invention.
FIG. 1b is a side cross-sectional view of the lighting device of FIG. 1a.
FIG. 2 is an enlarged view showing the light source portion, circuit board, and connection member of FIG. 1a.
FIG. 3(A)(B) illustrate a pull test and an example of crack generation for the connection member of FIG. 2.
FIG. 4a is a perspective view of a lighting device according to a first embodiment of the invention.
FIG. 4b is an example of a plan view of the lighting device of FIG. 4a.
FIG. 4c is a perspective view showing the connection member and fixing frame of the lighting device of FIG. 4a.
FIG. 5 is an example of a side cross-sectional view of the lighting device of FIG. 4a.
FIG. 6a is a first modified example of the lighting device according to the first embodiment of the invention.
FIG. 6b is a drawing showing the light source portion and fixing frame of FIG. 6a.
FIG. 7 is a second modified example of a lighting device according to the first embodiment of the invention.
FIG. 8 is a drawing showing an example of a fixing frame of the lighting device of FIG. 7.
FIG. 9 is a side cross-sectional view of a lighting device according to the second embodiment of the invention.
FIG. 10 is a side cross-sectional view of the lighting device of FIG. 9.
FIG. 11 is a plan view illustrating an example of the lighting device of FIG. 10.
FIG. 12 illustrates an example of the shape of a molding portion in the lighting device of FIG. 11.
FIG. 13 is a plan view illustrating another example of the lighting device of FIG. 10.
FIG. 14 illustrates an example of the shape of a molding portion in the lighting device of FIG. 13.
FIGS. 15 and 16 are drawings illustrating a manufacturing process of a molding portion in a lighting device according to the second embodiment of the invention.
FIG. 17 is a drawing illustrating another shape of the outer wall of FIG. 15.
FIG. 18 illustrates an example of a light guide module coupled to the lighting device of the first embodiment of the invention.
FIG. 19 is an example of a side cross-sectional view of the lighting device of FIG. 18.
FIG. 20 is a cross-sectional view of a lighting device having a reflector according to an embodiment of the invention.

### [Best Mode]

Hereinafter, preferred embodiments of the invention will be described in detail with reference to the accompanying drawings. The technical idea of the present invention is not limited to some of the described embodiments, but may be implemented in various different forms, and if it is within the scope of the technical idea of the present invention, one or more of its components may be selectively combined and substituted between embodiments. In addition, terms (including technical and scientific terms) used in the embodiments of the present invention, unless explicitly specifically defined and described, may be interpreted as a meaning that may be generally understood by those skilled in the art to which the present invention belongs, and terms generally used, such as terms defined in the dictionary, may be interpreted in consideration of the context of the related technology.

Terms used in the embodiments of the present invention are for describing the embodiments and are not intended to limit the present invention. In the present specification, the singular form may include a plural form unless specifically described in the phrase, and may include at least one of all combinations that may be combined as A, B, and C when described as "A and/or at least one (or more than one) of B and C". Also, terms such as first, second, A, B, (a), and (b) may be used to describe components of an embodiment of the present invention. These terms are intended only to distinguish the components from other components and are not determined by their nature, sequence, or order. Also, when a component is described as being 'connected', 'coupled' or 'connected' to another component, not only when the component is directly connected, coupled or connected to another component, it may also be 'connected', 'coupled', or 'connected' due to another component between that component and the other component. In addition, when each component is described as being formed or disposed "up (above) or down (bottom)", the up (down) or down (bottom) includes not only when two components are in direct contact with each other, but also when one or more components are formed or disposed between two components. Also, when expressed as "up (above) or down (bottom)", it may include the meaning of not only the upward direction but also the downward direction based on one component.

### <Lighting device>

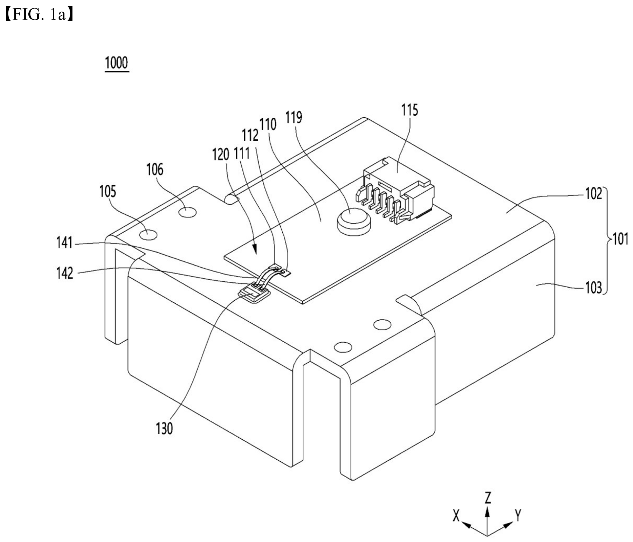

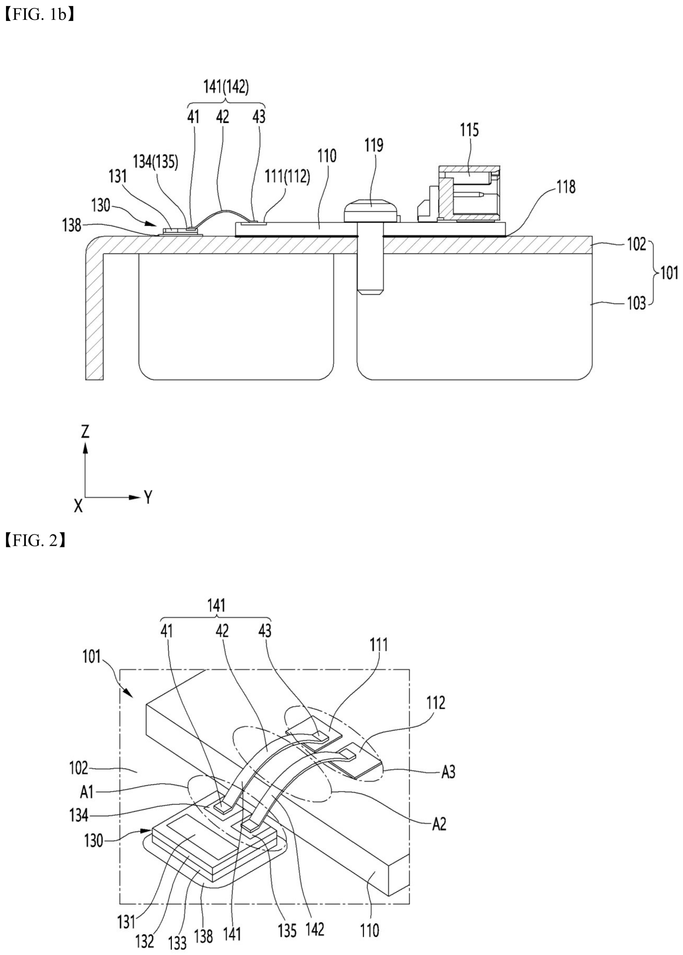

FIG. 1a is a perspective view of a lighting device according to the invention, FIG. 1b is a side cross-sectional view of the lighting device of FIG. 1a, and FIG. 2 is an enlarged view illustrating a light source portion, a circuit board, and a connection member of FIG. 1a.

Referring to FIGS. 1a, 1b, and 2, the lighting device 1000 may include a support plate 101, a circuit board 110 disposed on the support plate 101, a light source portion 130 disposed adjacent to the circuit board 110 on the support plate 101, and connection members 141 and 142 electrically connecting the light source portion 130 and the circuit board 110. The lighting device 1000 may be applied to various lamp devices requiring illumination, such as vehicle lamps, household lighting devices, and industrial lighting devices. For example, when applied to vehicle lamps, the lighting device may be applied to headlamps, side mirror lights, side marker lights, fog lights, tail lights, brake lights, daytime running lights, vehicle interior lighting, door scuffs, rear combination lamps, backup lamps, etc. The lighting device can also be applied to indoor and outdoor advertising devices, display devices, and various electric vehicle fields. The lighting device 1000 may be applied to, for example, a headlamp.

Within the lighting device 1000, the light source portion 130 and the circuit board 110 may be spaced apart in one direction, for example, in the second direction Y among the first and second directions X and Y. The first and second directions X and Y are mutually orthogonal directions, and a direction orthogonal to the first and second directions X and Y is a third direction Z, and the third direction Z may be a vertical direction.

The support plate 101 supports the circuit board 110 and the light source portion 130, and may conduct heat generated from the circuit board 110 and the light source portion 130. The support plate 101 may be a heat dissipation plate. The support plate 101 may be formed of a metal, or may be formed with a laminated structure of a thermally conductive material and a metal layer. The support plate 101 may be formed in a single layer or multiple layers. The thermally conductive material may include a ceramic material, AlN, or an aluminum material having an anodized surface layer. The metal may include at least one of Al, Ni, Mo, Cu, Cu-alloy, Cu-W, Ag, or Au, and may be formed in a single layer or in a multilayer of two or more metals. The support plate 101 may further include a heat dissipation fin at the bottom.

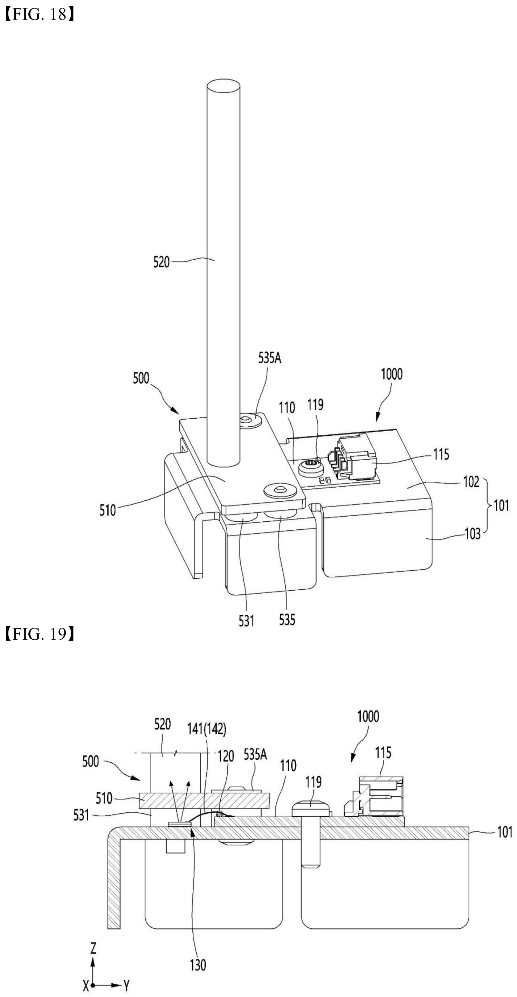

The support plate 101 includes an upper portion 102 and a side portion 103, and the upper surface area of the upper portion 102 may be provided as a larger area, for example, twice or more, for example, ten times or more, than the area of the circuit board 110. The side portions 103 may be bent downward from an edge of the upper portion 102 and may be disposed one or more along the outer side of the upper portion 102. Here, the downward direction is a direction facing the opposite side to the direction in which the circuit board 110 is disposed on the upper surface of the support plate 101. An empty space may be provided on the inner side of the side portion 103 and the lower side of the upper portion 102, or a structure such as a heat dissipation fin may be combined. Within the region of the upper portion 102, a plurality of coupling holes 105 and 106 disposed on both sides of the light source 130 in the second direction Y may be disposed in the first direction X. An external structure, for example, a light guide module 500 (See FIG. 18), may be coupled to the support plate 101 through the coupling holes 105 and 106.

The light source 130 is disposed on one side of the upper portion 102 of the support plate 101, and the circuit board 110 is disposed on the other side of the upper portion 102. The light source 130 may be disposed on one side of the circuit board 110. The light source 130 may be disposed on the support plate 101 and adhered to it using an adhesive member 138. The adhesive member 138 comprises a thermally conductive adhesive and may be made of an electrically insulating material, such as silicone or epoxy. The lower surface of the light source portion 130 may be adhered to the upper surface of the support plate 101 or to an area lower than the upper surface of the support plate 101. The adhesive member 138 may adhere the light source portion 130 to the upper surface 102. The adhesive member 138 may be positioned on the lower surface of the light source portion 130, protrude outward from the side surfaces of the light source portion 130, and be adhered to the lower portion of the side surface of the light source portion 130. The adhesive member 138 may conduct heat generated from the light source portion 130 to the support plate 101.

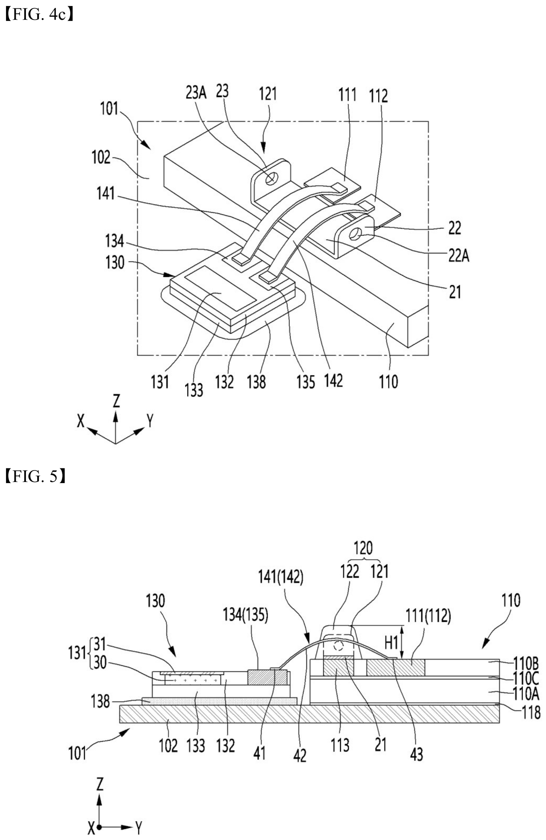

The circuit board 110 may comprise a resin material or a metal material. The circuit board 110 may be formed of any one of a ceramic-based PCB, a metal core PCB (MCPCB), a flexible PCB (FPCB), and a resin-based PCB. As shown in FIG. 5, the circuit board 110 may include a metal layer 110A at the bottom, a circuit layer (not shown) having pads 111 and 112 at the upper portion, a protective layer 110B made of an insulating material for protecting the circuit layer, and an insulating layer 110C between the metal layer 110A and the pads 111 and 112. The circuit board 110 may be provided as an MCPCB having a metal layer at the bottom, and may transfer heat to the support plate 101.

Here, the circuit board 110 may be fastened to the upper portion 102 by a fastening means 119, and the fastening means 119 may include one or more screws that fasten and adhere the circuit board 110 to the upper portion 102. As another example, the fastening means 119 may include a fastening structure and/or a hooking structure. The adhesive film 118 may adhere the circuit board 110 to the upper portion 102 and may be a thermally conductive tape. When the circuit board 110 is fastened by the fastening means 119, the adhesive film 118 may be removable, facilitating the separation of the circuit board 110. The circuit board 110 may be fastened to the upper surface of the support plate 101 using at least one or both of the fastening means 119 and the adhesive film 118.

The pads 111 and 112 of the circuit board 110 may include first and second pads 111 and 112 spaced apart from each other. The first and second pads 111 and 112 may be connected to a connector 115 disposed on an upper portion of the circuit board 110 through a circuit layer of the circuit board 110. The connector 115 may receive a driving signal and power from the outside. The pads 111 and 112 may be disposed on one side of the circuit board 110, and the connector 115 may be coupled to the other side of the circuit board 110. The fastening means 119 may be disposed on a region between the pads 111 and 112 and the connector 115. The first and second pads 111 and 112 are disposed adjacent to one side of the circuit board 110 and may be selected from Ti, Ru, Rh, Ir, Mg, Zn, Al, In, Ta, Pd, Co, Ni, Si, Ge, Ag, Au and optional alloys thereof. Each of the first and second pads 111 and 112 includes a single layer or multiple layers, and in the case of multiple layers, may include the same or different metals.

The circuit board 110 has the protective layer 110B on the metal layer 110A, and the protective layer 110B can protect the pads 111 and 112 and the circuit layer, and may open the bonding region or the upper surface region of the pads 111 and 112. The protective layer 110B may be an insulating material, such as a solder resist material, that partially exposes the pads 111 and 112.

The light source portion 130 may be bonded to the upper portion 102 of the support plate 101 using the adhesive member 138. The adhesive member 138 conducts heat generated from the light source portion 130 to the support plate 101. The adhesive member 138 may include a thermally conductive adhesive member, such as a TIM (Thermal Interface Material), containing metal powder or inorganic powder within a resin material. The side surface of the light source portion 130 may face a portion of the side surface of the circuit board 110. The light source portion 130 and the circuit board 110 may be electrically connected. The light source portion 130 and the circuit board 110 may be connected by at least one connection member 141 and 142. The light source portion 130 may include an OLED or an LED. The light source portion 130 operates when power is supplied through the circuit board 110 and emits light of at least one or more of blue, green, red, and white. For example, the light source portion 130 may emit white light.

The bonding pads 134 and 135 of the light source portion 130 are positioned adjacent to one side of the circuit board 110. The pads 111 and 112 of the circuit board 110 are positioned adjacent to the other side of the light source portion 130. The bonding pads 134 and 135 of the light source portion 130 may be positioned close to the circuit board 110 within the region of the light source portion 130. The upper surface of the circuit board 110 may be positioned higher than the upper surface of the light source portion 130 due to the thickness of the circuit board 110. In addition, the upper surfaces of the pads 111 and 112 of the circuit board 110 may be positioned higher than the upper surface positions of the bonding pads 134 and 135 of the light source portion 130. As another example, as shown in FIG. 22a, the lower surface of the circuit board 110 may be positioned within a receiving portion 108 that is lower than the upper surface of the support plate 101 on which the light source portion 130 is positioned.

The pads of the circuit board 110 may include first and second pads 111 and 112 that are spaced apart from each other, and the bonding pads of the light source portion 130 may include first and second bonding pads 134 and 135 that are spaced apart from each other. The connection members 141 and 142 may include a first connection member 141 and a second connection member 142 that are spaced apart from each other. The first pad 111 and the first bonding pad 134 may be connected to each other by the first connection member 141, and the second pad 112 and the second bonding pad 135 may be connected to each other by the second connection member 142. The pads 111 and 112, the bonding pads 134 and 135, and the connection members 141 and 142 are described as two each, but may be changed to one, three, or four depending on the connection form. In addition, the pads 111 and 112, the bonding pads 134 and 135, and the connection members 141 and 142 are described as having the same number, but at least one may be a different number. For example, the lower end of the light source portion 130 may be electrically connected to the support plate 101 through a via structure, and in this case, the number of bonding pads 134 and 135, pads 111 and 112, and connection members 141 and 142 may be implemented as one.

The first bonding pad 134 may function as a cathode terminal, and the second bonding pad 135 may function as an anode terminal. The first bonding pad 134 and the second bonding pad 135 may be selected from Ti, Ru, Rh, Ir, Mg, Zn, Al, In, Ta, Pd, Co, Ni, Si, Ge, Ag, Au, and optional alloys thereof. The first and second bonding pads 134 and 135 may include a single layer or multiple layers, and in the case of multiple layers, may include the same or different metals.

The first connection member 141 and the second connection member 142 may include an electrically conductive wire, and may include at least one of metals such as Au, Cu, Al, Ag, or optional alloys thereof. The first connection member 141 and the second connection member 142 are wires having a width greater than their thickness, for example, ribbon-shaped wires, and the width W of each may be 0.4 mm or more, for example, in the range of 0.4 mm to 0.9 mm, and the thickness may be 0.15 mm or less, for example, in the range of 0.07 mm to 0.15 mm. The width W of each of the first and second connection members 141 and 142 may be more than twice the thickness of the connection member 141 and 142, for example, more than twice and less than 15 times, and when it is smaller than the above range, the connection members 141 and 142 may be bent downward, and the bonding force may be reduced, the available current may be lowered, and the resistance to external force may be weakened. Additionally, if the width W of the connection member 141 and 142 is greater than the above range, there is a problem in that the size of the bonding pad 134 and 135 or the pad 111 and 112 increases or material is wasted.

The first connection member 141 and the second connection member 142 include a first end portion 41, a second end portion 43, and an intermediate wire portion 42. The first end portion 41 is bonded to the first bonding pad 134 and the second bonding pad 135, respectively, and the second end portion 43 is bonded to the first pad 111 and the second pad 112, respectively. The intermediate wire portion 42 is connected between the first end portion 41 and the second end portion 43 and may have a curved shape. The intermediate wire portion 42 may have, for example, a convex curved shape.

The intermediate wire portion 42 of the first connection member 141 connects the first end portion 41 bonded to the first bonding pad 134 and the second end portion 43 bonded to the first pad 111. The intermediate wire portion 42 of the second connection member 142 connects the first end portion 41 bonded to the second bonding pad 135 and the second end portion 43 bonded to the second pad 112. The intermediate wire portion 42 may extend from the other side of the light source portion 130 to one side of the circuit board 110. The intermediate wire portion 42 may have a length longer than the distance between the circuit board 110 and the light source portion 130.

The upper surface heights of the first end portion 41 and the second end portion 43 of the connection member 141 and 142 may be different from each other. For example, the upper surface height of the first end portion 41 of the connection member 141 and 142 may be positioned lower than the upper surface height of the second end portion 43, and the height of the highest point of the intermediate wire portion 42 may be positioned higher than the upper surface position of the first end portion 41. The height of the highest point of the intermediate wire portion 42 may be positioned higher than the upper surface position of the second end portion 43.

The first connection member 141 and the second connection member 142 may or may not be parallel to each other. When the first connection member 141 and the second connection member 142 are parallel to each other, the distance between the first end portions 41 of the first connection member 141 and the second connection member 142 and the distance between the second end portions 43 may be the same. The distance between the intermediate wire portions 42 of the first and second connection members 141 and 142 may be the same as the spacing between the first end portions 41 and the distance between the second end portions 43.

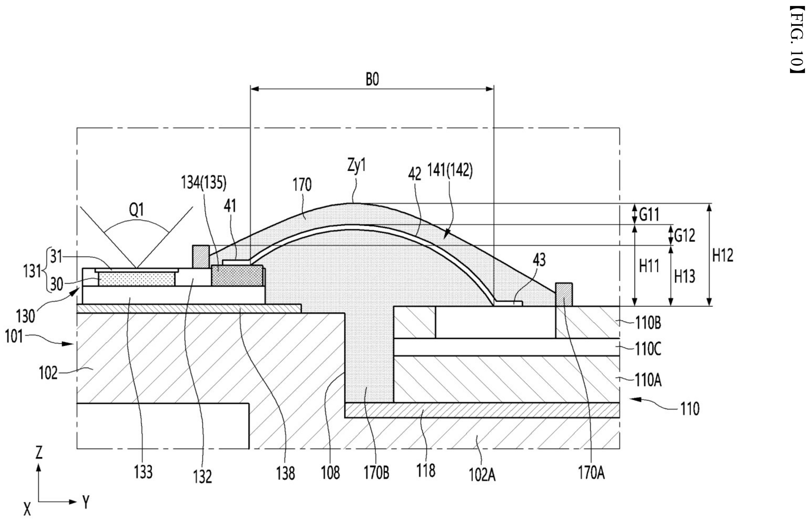

When the first connection member 141 and the second connection member 142 are not parallel to each other, the distance between the first end portions 41 of the first connection member 141 and the second connection member 142 may be different from the distance between the second end portions 43. For example, as shown in FIG. 10, the distance E1 between the first end portions 41 of the first connection member 141 and the second connection member 142 may be smaller than the distance E2 between the second end portions 43. In this case, imaginary straight lines extending along the first connection member 141 and the second connection member 142 may intersect each other.

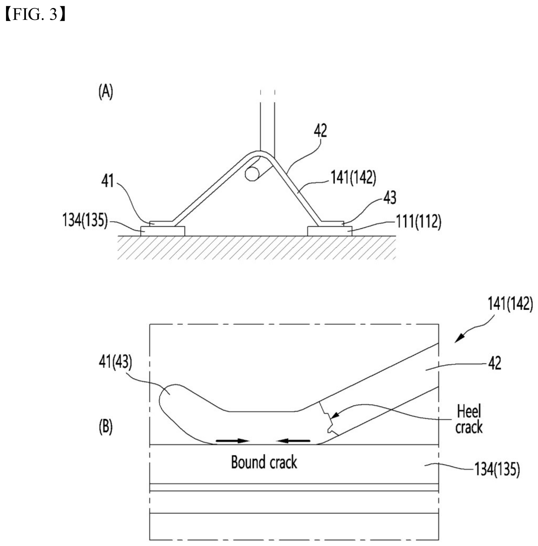

As shown in FIGS. 2 and 3, with respect to the upper surface of the support plate 101, the first connection member 141 and the second connection member 142 each have a height difference between the first end portion 41 and the second end portion 43. When the first and second end portions 41 and 43 are bonded to the pads 111 and 112 and the bonding pads 134 and 135, respectively, a bonding failure or an open failure may occur at each end portion 41 and 43 due to the height difference between the first end portion 41 and the second end portion 43 of the first and second connection members 141 and 142. The bonding may be performed through an ultrasonic soldering process, and heat of 200 degrees or more is generated.

In addition, as shown in FIG. 3(A), when a wire pull-off test is performed after bonding of the connection member 141 and 142, an open defect due to a heel crack or the like may occur at the connection portion between the first end portion 41 and the intermediate wire portion 42 of the connection member 141 and 142 and/or the connection portion or bend portion between the second end portion 43 and the intermediate wire portion 42, or a bound crack or the like may occur at the boundary portion between the first end portion 41 or the second end portion 43 and the pad 111 and 112 or the bonding pad 134 and 135. In order to prevent open defects of these connection members 141 and 142, the design is made by taking into consideration the straight-line distance between the first end portion 41 and the second end portion 43, the inclination angle extending from the first end portion 41 to the intermediate wire portion 42, and the inclination angle extending from the second end portion 43 to the intermediate wire portion 42. However, when the temperature change is large or there is an external impact, cracks may occur at the boundary between the intermediate wire portion 42 and the first and second end portions 41 and 43 due to the flow of the intermediate wire portion 42 of the connection member 141 and 142. That is, it may be seen that the joint where the wire is bent during soldering is most vulnerable to external force and the environment.

An embodiment of the invention may provide a member having a molding portion made of a resin material in at least one of a region A1 of a first end portion 41, a region A2 of an intermediate wire portion 42, or a region A3 of a second end portion 43 of the connection members 141 and 142. The member having the molding portion molds at least one, two or more, or all of the region A1 of the first end portion 41, the region A2 of the intermediate wire portion 42, or the region A3 of the second end portion 43 of the connection member 141 and 142, and may fix the position of at least a part of the connection member 141 and 142 from external impact, or may prevent metal oxidation by inhibiting moisture penetration into the regions A1 and A3 of the first and second end portions 41 and 42. The molding portion may mold at least one or more of the first end portion 41, the intermediate wire portion 42, and the second end portion 43 of the first connection member 141. The molding portion may mold at least one or more of the first end portion 41, the intermediate wire portion 42, and the second end portion 43 of the second connection member 142. The member including the molding portion may be made of a material with a low elastic modulus, which may reduce the stress transmitted to the wire and increase the bonding strength of the bonding portion. When evaluating the wire bonding strength (recognized strength) using the full test, the reference matching strength is approximately 135 gf per bonding area, and when molded with the member including the molding portion, the reference bonding strength is more than twice that. The molding portion and the member including the molding portion will be described in detail in the embodiments described below.

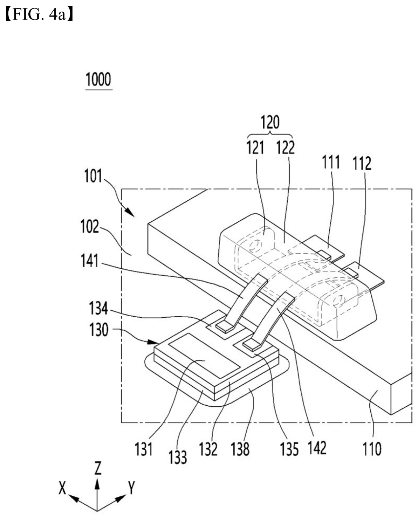

FIGS. 4a to 4c and FIG. 5 are examples of a lighting device according to a first embodiment of the invention.

As shown in FIGS. 4a to 4c and FIG. 5, the lighting device 1000 includes a fixing member 120 having a support plate 101, a circuit board 110 and a light source portion 130 on the support plate 101, a connection member 141 and 142 connecting the circuit board 110 and the light source portion 130, and a molding portion 122 covering a portion of the connection member 141 and 142. The light source portion 130 includes a support member 133 and a light emitting device 131 disposed on the support member 133, and the light emitting device 131 may include, for example, one or more light emitting devices. The light source portion 130 may include a resin member 132, and the resin member 132 may be arranged around the periphery of the light emitting device 131.

The support member 133 may include a ceramic substrate or a semiconductor substrate. The support member 133 may be provided as a ceramic layer or a metal layer. The support member 133 may conduct heat generated from the light emitting device 131 through the support plate 101. The support member 133 may be bonded to the support plate 101 using the adhesive member 138. The adhesive member 138 may be in contact along the lower surface and the lower side surface of the support member 133. Since the adhesive member 138 is in contact with the lower surface and the lower side surface of the support member 133, heat generated through the support member 133 may be conducted to the support plate 101.

The support member 133 can support the light emitting device 131 and include a conductive pattern electrically connected to the light emitting device 131. The light source portion 130 can have the light emitting device 131 on one side and the bonding pads 134 and 135 on the other side. The light emitting device 131 may be arranged on one side of the support member 131, and the bonding pads 134 and 135 may be arranged on the other side of the support member 131. The upper surface height of the above bonding pads 134 and 135 may be arranged higher than the upper surface height of the resin member 132 or may be arranged at the same height as the upper surface height of the resin member 132. A protection element (not shown) for protecting the light emitting devices 131 may be arranged on the support member 133, and the protection element may be implemented as a thyristor, a Zener diode, or a TVS (Transient voltage suppression), and protects the light emitting devices 131 from ESD (electro static discharge).

The light emitting device 131 may include at least one of a blue, green, or red LED chip. The light emitting device 131 may be provided as any one of vertical type, horizontal type, or flip type chips. The light emitting device 131 may include a package having an LED chip and a transparent resin molding portion disposed on the LED chip. The resin member 132 may be formed of a single layer or multiple layers of a material including silicone or epoxy. The resin member 132 may further include a convex lens (not shown) on the upper portion. The light emitting device 131 may include at least one light emitting chip 30 disposed on the support member 133 and a wavelength conversion layer 31 disposed on the at least one light emitting chip 30. The light emitting chip 30 may be arranged in one or more, and may include a plurality of semiconductor layers made of compound semiconductors of group II and group VI elements and/or compound semiconductors of group III and group V elements, and at least one or all of the plurality of semiconductor layers may include a compound semiconductor of a series such as AlInGaN, InGaN, AlGaN, GaN, GaAs, InGaP, AllnGaP, InP, and InGaAs. The wavelength conversion layer 31 is disposed on the light emitting chip 30 and may cover the entire upper surface of the light emitting chip 30. The wavelength conversion layer 31 converts a portion of light emitted from the light emitting chip 30. The wavelength conversion layer 31 may be in contact with the upper surface of the light emitting chip 30 and a portion of the resin member 132. The wavelength conversion layer 31 may include at least one or two or more of a yellow phosphor, a green phosphor, a blue phosphor, and a red phosphor. The light emitting device 131 can emit white light. The light emitting device 131 can emit light with the highest luminous intensity in a direction perpendicular to the upper surface of the light emitting device 131. As another example, the light emitting device 131 may include LED chips with different wavelengths, in which case the wavelength conversion layer may be omitted. The LED chips with different wavelengths may include a red LED chip, a green LED chip, and a blue LED chip.

The light emitting device 131 may be positioned on one upper side of the support member 133, and the bonding pads 134 and 135 may be positioned on the other upper side of the support member 133. The bonding pads 134 and 135 may include a first bonding pad 134 connected to the cathode of the light emitting device 131 and a second bonding pad 135 connected to the anode of the light emitting device 131. The support member 133 has an electrode pattern on which the first and second bonding pads 134 and 135 are arranged, and the electrode pattern may electrically connect the light emitting device 131 and the first and second bonding pads 134 and 135. The first and second bonding pads 134 and 135 may be exposed on the upper surface of the other side of the support member 133. The distance between the light source portion 130 and the circuit board 110 may be 3 mm or more, for example, in the range of 3 mm to 10 mm or in the range of 3 mm to 8 mm. If the distance is less than the above range, the buffer space due to thermal expansion differences between the light source portion 130 and the circuit board 110 will decrease, which may degrade the electrical reliability of the first and second connection members 141 and 142 when the light source portion 130 moves. If the distance between the light source portion 130 and the circuit board 110 is greater than the above range, the length or material of the first and second connection members 141 and 142 will increase.

The fixing member 120 may be positioned on either or both of the circuit board 110 and the support plate 101. The fixing member 120 includes the molding portion 122, and the molding portion 122 may mold at least one region of each of the connection members 141 and 142 or different regions. The fixing member 120 may include a fixing frame 121 for fixing the molding portion 122. The fixing frame 121 may be disposed at a lower portion of the fixing member 120, and the molding portion 122 may be disposed at an upper portion of the fixing member 120. The fixing frame 121 may be disposed on at least one or both of the circuit board 110 and the support plate 101. The fixing frame 121 may be adhered or bonded to the circuit board 110 and/or the support plate 101. The fixing frame 121 may be fixed on the circuit board 110 and/or the support plate 101. The fixing frame 121 may fix the position of the molding portion 122 under the molding portion 122. The fixing frame 121 may be in contact with at least a portion of the molding portion 122, and may be coupled to at least one of the inner or outer sides of the molding portion 122, or may be coupled to different regions of the molding portion 122. As another example, the fixing member 120 may be composed of the molding portion 122 without the fixing frame.

The molding portion 122 may be in contact with at least one or both of the first and second connection members 141 and 142 and may fix the position of at least a portion of each of the first and second connection members 141 and 142. The molding portion 122 may fix the intermediate wire portion 42 of at least one of the first and second connection members 141 and 142 on the circuit board 110. The molding portion 122 surrounds and supports the perimeter of the intermediate wire portion 42 of the first and second connection members 141 and 142, thereby fixing the position of the intermediate wire portion 42.

The fixing frame 121 may be positioned on a region that vertically overlaps with the circuit board 110. The molding portion 122 molds and supports a region of the intermediate wire portion 42 of the first and second connection members 141 and 142 that vertically overlaps with the circuit board 110. The molding portion 122 molds and supports a region of the intermediate wire portion 42 of the first and second connection members 141 and 142 that vertically overlaps with the region between one side of the circuit board 110 and the pad 111 and 112.

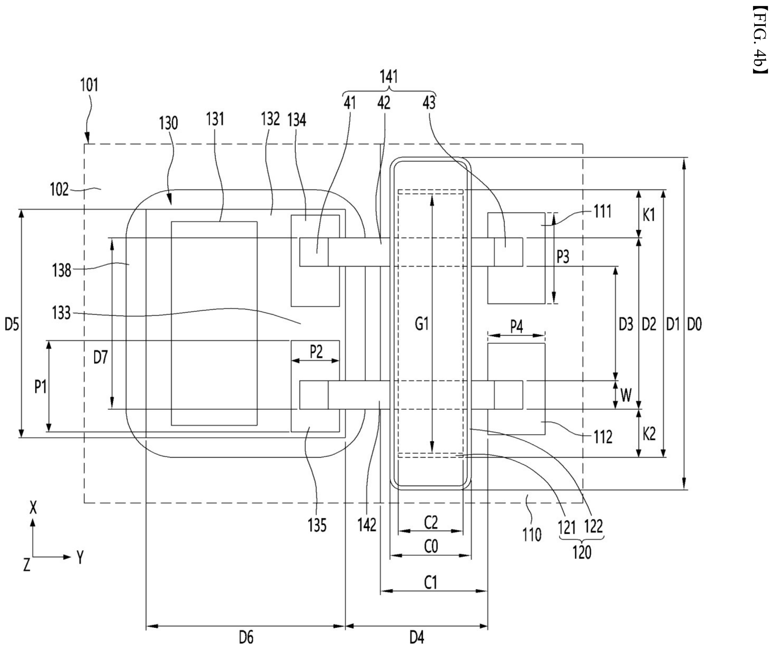

The fixing frame 121 may be attached or bonded to the circuit board 110. The fixing frame 121 may be attached to a sub pad 113 disposed within the circuit board 110 using a bonding member (not shown). The fixing frame 121 may include a bottom portion 21 attached to the sub pad 113, and support portions 22 and 23 bent from one or both ends of the bottom portion 21. The support portions 22 and 23 may be bent from one or both ends of the bottom portion 21 in a third direction Z of the circuit board 110. The bent portion between the bottom portion 21 and the support portions 22 and 23 may include a curved surface. The bottom portion 21 may be disposed between the pads 111 and 112 and one side of the circuit board 110. As shown in FIG. 4b, the distance G1 between the support portions 22 and 23 on both sides of the fixing frame 121 may be greater than the maximum length in the first direction X of the region having the pads 111 and 112. The distance G1 between the support portions 22 and 23 in the first direction X may be greater than the maximum length D2 of the region having the connection members 141 and 142.

The sub pad 113 may be formed of the same material as the pads 111 and 112. The fixing frame 121 may be formed of a metal material, for example, at least one of Cu, Ti, Al, Pd, Co, Ni, Ag, and Au, or an alloy of two or more of the above metals. The fixing frame 121 may be formed in a single layer or multiple layers using the metal. The number of the fixing frames 121 and the number of the molding portions 122 may be the same. As another example, the number of the molding portions 122 may be greater than the number of the fixing frames 121, and in this case, the molding portions 122 may be formed in different areas of the fixing frames 121. As another example, the fixing frames 121 may be made of a non-metallic material.

The molding portion 122 is disposed on the fixing frame 121, and the fixing frame 121 may be disposed within the region of the molding portion 122. That is, the fixing frame 121 may be attached to the upper surface of the circuit board 110 and embedded in the lower portion of the molding portion 122. The molding portion 122 may be disposed on the surface of the bottom portion 21 of the fixing frame 121 and in the region between the support portions 22 and 23. The molding portion 122 may be disposed on the upper and outer sides of the support portions 22 and 23. The molding portion 122 may be disposed around the periphery of the support portions 22 and 23. Accordingly, the molding portion 122 can cover the entire upper surface of the fixing frame 121. In addition, the molding portion 122 may be in contact with at least one or both of the surface of the fixing frame 121 and the upper surface of the circuit board 110. The molding portion 122 may be disposed on a region between the first end portion 41 and the second end portion 43 of the first connection member 141. The molding portion 122 may be disposed in a region between the first end portion 41 and the second end portion 43 of the second connection member 142. The molding portion 122 may cover a region with the highest point of the first connection member 141, and the height of the uppermost end of the molding portion 122 may be positioned higher than the highest point of the first connection member 141. The molding portion 122 covers the highest point of the second connection member 142, and the uppermost end of the molding portion 122 may be positioned higher than the highest point of the second connection member 142. That is, the molding portion 122 may cover the highest point of the intermediate wire portion 42 of the first and second connection members 141 and 142, and may cover the region of the intermediate wire portion 42 that vertically overlaps the circuit board 110 on the circuit board 110.

The molding portion 122 may include a resin material such as silicone or epoxy, acrylate, urethane, polyolefin, UV resin, or an insulating material, or a selective mixture thereof. The molding portion 122 may be dispensed onto the fixing frame 121 and then cured using a method selected from high-temperature curing, room-temperature curing, or UV curing. The molding portion 122 may be an adhesive or insulating member adhered to the connection members 141 and 142. The molding portion 122 may include a diffusion agent or a reflective material therein. The molding portion 122 has a plurality of side surfaces and an upper surface, and the corner portions between the plurality of side surfaces may include curved or angular surfaces, for example, curved surfaces, and the corner portions between each of the side surfaces and the upper surface may have curved or angular surfaces, for example, curved surfaces.

The support portions 22 and 23 of the fixing frame 121 may be arranged as first and second support portions 22 and 23 arranged on both sides of the bottom portion 21 in the first direction X, or as the first support portion 22 or the second support portion 23 arranged on one or the other end of the bottom portion 21 in the first direction X. The upper surface of the support portion 22 and 23 may have a corner portion in the second direction Y as a curved surface or an angled surface. The support portion 22 and 23 may protrude toward the outer region of the intermediate wire portion 42 of each of the first and second connection members 141 and 142. The fixing frame 121 may further include a support portion (not shown) protruding into the region between the first and second connection members 141 and 142. The support portions 22 and 23 may be one or more in number, protrude from the fixing frame 121 toward the upper surface of the molding portion 122, and may be arranged on a region that does not overlap the intermediate wire portions 42 of the first and second connection members 141 and 142 and the upper surface of the support plate 101 in a direction perpendicular to the upper surface.

The fixing member 120 and the first and second connection members 141 and 142 may overlap in a direction perpendicular to the upper surface of the support plate 101 (i.e., the Z direction). Part of the fixing member 120 and the first and second connection members 141 and 142 may overlap in a direction perpendicular to the upper surface of the support plate 101. Part of the first and second connection members 141 and 142, the fixing member 120, and the circuit board 110 may overlap in a direction perpendicular to the upper surface of the support plate 101. The molding portion 122 of the fixing member 120 and part of the first and second connection members 141 and 142 may overlap in a direction perpendicular to the upper surface of the support plate 101.

The fixing member 120 may space the position of the intermediate wire portion 42 of the first and second connection members 141 and 142 from the upper surface of the circuit board 110. The molding portion 122 may space the position of the intermediate wire portion 42 of the first and second connection members 141 and 142 from the upper surface of the fixing frame 121. The region with the highest point of the intermediate wire portion 42 may be disposed between the upper surface of the circuit board 110 and the upper surface of the molding portion 122. The region with the highest point of the intermediate wire portion 42 may be disposed between the lower surface of the molding portion 122 and the upper surface of the molding portion 122. The region with the highest point of the intermediate wire portion 42 may be disposed between the upper surface of the fixing frame 121 and the molding portion 122.

The upper height H1 of the molding portion 122 based on the upper surface of the circuit board 110 may be higher than the height of the highest point of the connection member 141 and 142. The positions of the highest points of the first and second connection members 141 and 142 based on the upper surface of the circuit board 110 may be arranged between the upper end of the molding portion 122 and the fixing frame 121. The height of the highest points of the first and second connection members 141 and 142 based on the upper surface of the circuit board 110 may be higher than the bottom portion 21 of the fixing frame 121 and lower than the upper height of the support portion 22 and 23. As another example, the positions of the highest points of the first and second connection members 141 and 142 based on the upper surface of the circuit board 110 may be higher than the upper end of the support portion 22 and 23 of the fixing frame 121.

At least one or both of the support portions 22 and 23 of the fixing frame 121 may include holes 22A and 23A on the inside. The molding portion 122 may be coupled to the holes 22A and 23A of the support portions 22 and 23. Since the molding portion 122 is coupled to the holes 22A and 23A of the support portions 22 and 23, detachment or separation of the molding portion 122 from the fixing frame 121 may be prevented. The holes 22A and 23A may be circular or polygonal in shape, and may be arranged one or more times within each support portion 22 and 23. As another example, the fixing frame 121 may include at least one of a groove, a catching protrusion, or a catching protrusion for securing the molding portion 122.

As shown in FIG. 4b, the length D0 of the fixing member 120 is the length in the first direction X orthogonal to the extension direction of the connection members 141 and 142, and is the maximum length of the molding portion 122 in the first direction X. The length D0 of the fixing member 120 in the first direction X may be greater than the maximum length in the first direction X of the region where the first and second pads 111 and 112 are disposed. The length D0 of the fixing member 120 may be greater than the minimum separation distance D3 between the first and second connection members 141 and 142 in the first direction X and greater than the maximum length D2 of the region having the first and second connection members 141 and 142.

The length D1 of the fixing frame 121 in the first direction X may be greater than the maximum length in the first direction X of the region having the first bonding pad 134 and the second bonding pad 135. The length D1 of the fixing frame 121 in the first direction X may be greater than the length D5 of the light source portion 130.

The length D0 of the fixing member 120 in the first direction X varies depending on the extension direction of the connection members 141 and 142, and may be, for example, a length capable of covering the middle region of two connection members 141 and 142 spaced apart in the first direction X, or may have a length that is 1.5 times or greater than the length (maximum separation distance) of the region where the two connection members 141 and 142 are disposed. The length D1 of the first direction X of the fixing frame 121 may be greater than the maximum length of the first direction X of the region having the first pad 111 and the second pad 112.

The two side surfaces of the fixing member 120 in the first direction X may be disposed further outward in the first direction X than the outer side of each bonding pad 134 and 135 in the first direction X and may be disposed further outward than the outer side of each pad 111 and 112 in the first direction X. The fixing member 120 can prevent vertical and horizontal movement of the first and second connection members 141 and 142 with respect to the upper surface of the circuit board 110, thereby preventing a short circuit caused by contact between the connection members 141 and 142 and the upper portion 102 of the support plate 101.

The bottom width C2 of the fixing frame 121 in the second direction Y may be equal to or smaller than a width of the upper surface of the molding portion 122, and may be smaller than the bottom width C0 of the fixing member 120. Since the bottom width C0 of the fixing member 120 is disposed to be larger than the bottom width C2 of the fixing frame 121, the molding portion 122 may seal the fixing frame 121 and increase the bonding area between the molding portion 122 and the circuit board 110.

The bottom width C0 of the fixing member 120 in the second direction Y is the bottom width of the molding portion 122 and may be smaller than the distance C1 between the pads 111 and 112 of the circuit board 110 and one side surface of the circuit board 110. Accordingly, the fixing member 120 may be disposed between the pads 111 and 112 and one side surface of the circuit board 110 on the upper surface of the circuit board 110. The fixing member 120 may be disposed between the light source portion 130 and the pads 111 and 112. The distance D4 between the light source portion 130 and the pads 111 and 112 of the circuit board 110 may be more than 1 time, for example, more than 1 time and less than 3 times the bottom width C0 of the fixing member 120. Here, the width P2 of the first and second bonding pads 134 and 135 in the second direction Y may be 0.7 mm or more, for example, in the range of 0.7 mm to 1 mm, and the length P1 in the first direction X may be 1 mm or more, for example, in the range of 1 mm to 1.4 mm. The width P4 of the first and second pads 111 and 112 in the second direction Y may be arranged in the range of 80% to 120% of the width P2 of the first and second bonding pads 134 and 135, respectively. The length P3 of the first and second pads 111 and 112 in the first direction X may be arranged in the range of 80% to 120% of the length P1 of the first and second bonding pads 134 and 135, respectively.

In the first direction X, both ends of the fixing frame 121 may further protrude a predetermined distance K1 and K2 from the outer side of each of the first and second connection members 141 and 142 toward the outer side of each of the first and second bonding pads 134 and 135, for example, the distance K1 and K2 may be 0.2 mm or more, for example, in the range of 0.2 mm to 0.8 mm. The distance K1 and K2 may be a distance that can prevent the problem of the intermediate wire portion 42 of the connection member 141 and 142 and the support portion 22 and 23 of the fixing frame 121 from coming into contact when the intermediate wire portion 42 of the connection member 141 and 142 moves to both sides in the first direction X. The fixing member 120 fixes and supports the connection members 141 and 142 on the circuit board 110, thereby preventing movement of the connection members 141 and 142 and preventing a short circuit between the connection members 141 and 142 and the support plate 101. Since each of the support members 22 and 23 of the fixing frame 121 is coupled to the interior of the molding portion 122, expansion or contraction of the molding portion 122 in the first direction X may be suppressed. In addition, by protecting the area between the two ends of the connection members 141 and 142 by an external force with the molding portion 122, deformation of the connection members 141 and 142 may be reduced, external exposure may be reduced, and a short circuit problem of the intermediate wire portion 42 may be prevented.

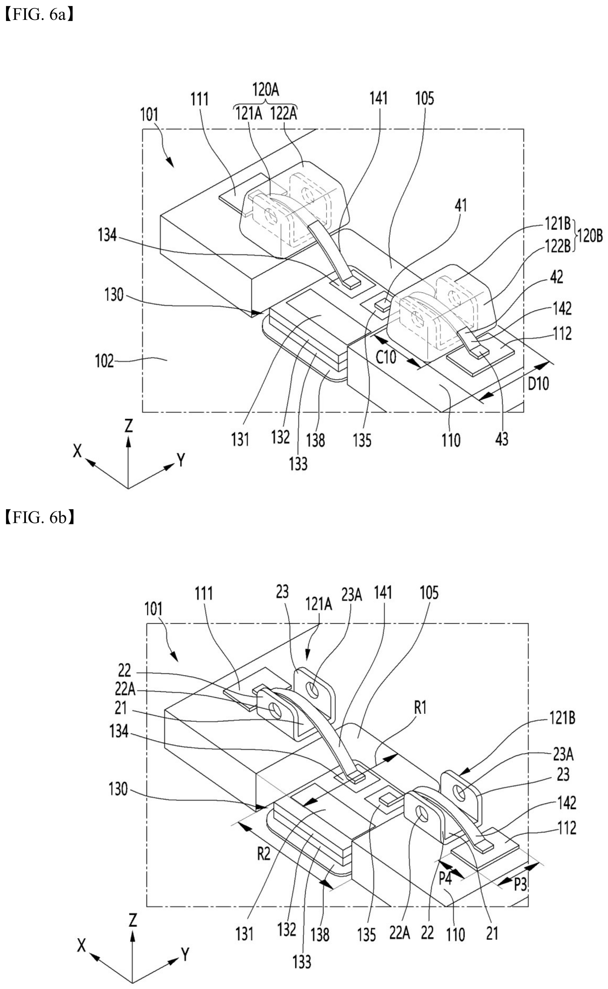

FIGS. 6a and 6b illustrate a first modified example of a lighting device according to a first embodiment of the invention.

Referring to FIGS. 6a and 6b, the lighting device includes a recess 105 in which the light source portion 130 is accommodated, and the recess 105 may be concave from one side of the circuit board 110 toward the other side. The length R2 of the recess 105 in the first direction X may be greater than the length D5 (See FIG. 4b) of the light source portion 130 in the first direction, and for example, the length R2 may be more than one time and less than two times the length D5. The length R1 of the second direction Y of the recess 105 may be greater than the length D6 (See FIG. 4b) of the light source portion 130 in the second direction Y, and for example, the length R1 may be more than 0.5 times and less than 2 times the length D6. That is, the light source portion 130 may be partially or entirely accommodated in the first direction X within the recess 105. Accordingly, a part of the light source portion 130 may be disposed inside one side of the circuit board 110.

A first pad 111 and a second pad 112 may be disposed on both sides of the first direction X of the recess 105 of the circuit board 110. That is, the first and second pads 111 and 112 may be spaced apart in the first direction X by a distance greater than the length R2 of the recess 105. The top view shape of the recess 105 can have a shape corresponding to the top view shape of the light source portion 130, and may be, for example, a square shape or a square shape having curved corners. In addition, the top view shape of the recess 105 may be a shape in which at least a portion of the side surface of the recess 105 has a curved surface. When the light source portion 130 is accommodated in the recess 105, the adhesive member 138 that adheres the light source portion 130 to the upper portion 102 may be placed within the recess 105. The adhesive member 138 may be spaced apart from the inner surface of the recess 105 or may be in contact with the inner surface of the recess 105. The light source portion 130 may be accommodated and stably positioned within the recess 105.

The fixing members 120A and 120B may include first and second fixing members 120A and 120B spaced apart in a first direction X and positioned on both sides of the light source portion 130. The first fixing member 120A and the second fixing member 120B may correspond to each other on both sides of the recess 105 in the first direction X. For example, the first and second fixing members 120A and 120B may be positioned facing each other on both sides of the recess 105 in the first direction X.

The first bonding pad 134 of the light source portion 130 and the first pad 111 of the circuit board 110 are connected by the first connection member 141, and the second bonding pad 135 of the light source portion 130 and the second pad 112 of the circuit board 110 are connected by the second connection member 142. The first connection member 141 and the second connection member 142 may extend in a first direction X.

Each of the first and second fixing members 120A and 120B includes a fixing frame 121A and 121B and a molding portion 122A and 122B. The first fixing member 120A may be disposed in a region between the recess 105 and the first pad 111. The second fixing member 120B may be arranged in the region between the recess 105 and the second pad 112. The distance between the first and second molding portions 122A and 122B may be spaced apart by a length R2 of the first direction X of the recess 105. As another example, each of the first and second fixing members 120A and 120B may be configured as a molding portion 122A and 122B without a fixing frame 121A and 121B.

The first molding portion 122A of the first fixing member 120A fixes a portion of the first connection member 141 on the circuit board 110, and the second molding portion 122A of the second fixing member 120B fixes a portion of the second connection member 142 on the circuit board 110. The first molding portion 122A may be disposed in an area of the upper surface of the circuit board 110 that vertically overlaps with the intermediate wire portion 42 of the first connection member 141. The second molding portion 122B may be disposed in a region of the upper surface of the circuit board 110 that vertically overlaps with the intermediate wire portion 42 of the second connection member 142. Portions of the first and second connection members 141 and 142 are molded into the molding portions 122A and 122B of the first and second fixing members 120A and 120B, and the positions of the intermediate wire portions 42 of the first and second connection members 141 and 142 may be fixed by the molding portions 122A and 122B. Each of the fixing frames 121A and 121B may be adhesively bonded to the circuit board 110 or joined to a sub pad 113 (See FIG. 5).

With respect to the upper surface of the circuit board 110, the highest point of the first connection member 141 may be lower than the highest point of the first fixing member 120A or the highest point of the first molding portion 122A. The position of the highest point of the second connection member 142 based on the upper surface of the circuit board 110 may be lower than the position of the highest point of the second fixing member 120B or the highest point of the second molding portion 122B. The length D10 of each of the first and second fixing members 120A and 120B in the first direction X may be greater than the length C10 in the second direction Y. The length D10 of each of the first and second fixing members 120A and 120B in the second direction Y may be greater than the length P3 of each of the first and second pads 111 and 112 in the second direction Y, and the length C10 of each of the first and second fixing members 120A and 120B in the first direction X may be greater than the length P4 of each of the first and second pads 111 and 112 in the first direction X. Here, the lengths P3 and P4 of the first and second pads 111 and 112 in the first and second directions X and Y may vary depending on the direction in which the connection member 141 and 142 extends.

The first and second fixing members 120A and 120B may include a bottom portion 21 as disclosed in Fig. 6(b) and support portions 22 and 23 bent on one or both sides of the second direction Y of the bottom portion 21. The molding portions 122A and 122B may cover the bottom portion 21 and the support portions 22 and 23. The height of the highest point of the first and second connection members 141 and 142 based on the upper surface of the circuit board 110 may be higher than the bottom portion 21 of the fixing frame 121A and lower than the upper height of the support portions 22 and 23. As another example, the height of the highest point of the first and second connection members 141 and 142 based on the upper surface of the circuit board 110 may be higher than the upper height of the support portion 22 and 23 of the fixing frame 121A and lower than the high point height of the first and second molding portions 122A and 122B. The length D10 of each of the molding portion 122A and 122B or the fixing member 120A and 120B in the second direction Y may be smaller than the length R1 of the recess 105 in the second direction Y. The distance in the first direction X between the first and second fixing members 120A and 120B may be greater than or equal to the length R2 of the recess 105 in the first direction X, and may reduce interference with light emitted from the light source portion 130.

The molding portion 122A and 122B may be formed within the hole 22A and 23A of the support portion 22 and 23. That is, the molding portion 122A and 122B may extend inside the hole 22A and 23A of the support portion 22 and 23, and inside and outside of the support portion 22 and 23, and may be adhered and fixed to the fixing frame 121A and 121B. In order to determine the angle of light emitted from the light emitting device 131, the inner surface of the molding portion 122A and 122B may be inclined with respect to the upper surface of the circuit board 110, or the area between the first and second fixing members 120A and 120B and the molding portion 122A and 122B may not overlap with the upper area of the light emitting device 131 in the first direction X. The region between the first and second fixing members 120A and 120B and the molding portions 122A and 122B may not overlap with the upper region of the light emitting device 131 in the second direction Y.

The length D10 of each of the first and second fixing members 120A and 120B in the second direction Y varies depending on the extension direction of the first and second connection members 141 and 142, and may be, for example, a length capable of covering a portion of one connection member 141 and 142, or may be two or more times, for example, three or more times, larger than the width W (See FIG. 4b) of the one connection member 141 and 142. The first and second fixing members 120A and 120B secure and support portions of the first and second connection members 141 and 142, for example, a portion of the intermediate wire portion 42, respectively, on the circuit board 110. This prevents movement of the first and second connection members 141 and 142, and prevents short circuits between the first and second connection members 141 and 142 and the support plate 101.

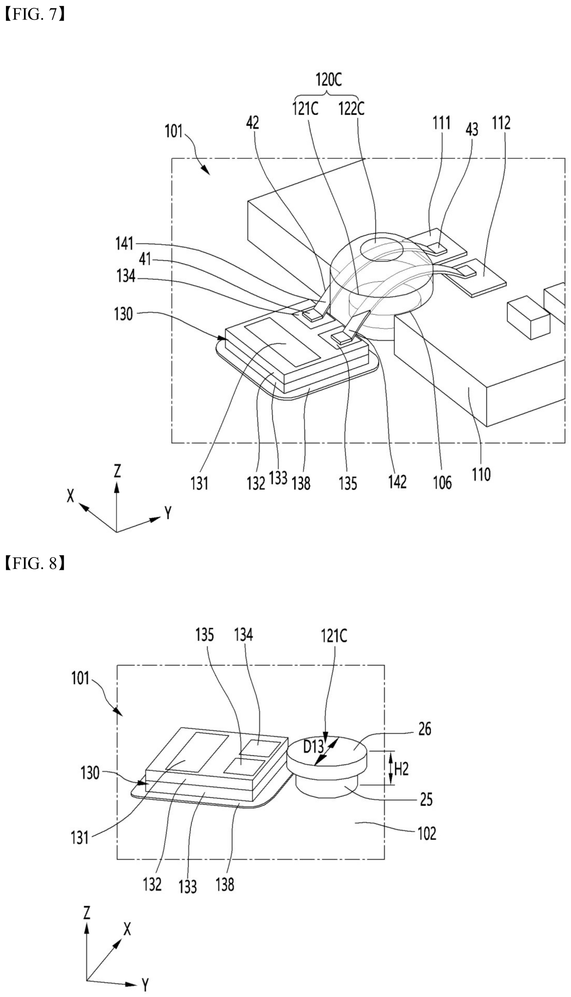

FIGS. 7 and 8 illustrate a second modified example of a lighting device according to the first embodiment of the invention.

Referring to FIGS. 7 and 8, the circuit board 110 may include a concave recess 106 on one side. The recess 106 may have a top-view circular, oval, or semicircular shape. A portion or a lower portion of the fixing member 120C may be positioned in the recess 106. Since the fixing member 120C is positioned within the recess 106, the distance between the light source portion 130 and the circuit board 110 may be reduced.

The fixing member 120C includes a fixing frame 121C and a molding portion 122C. The fixing frame 121C may be bonded to the upper surface of the support plate 101 with an adhesive or bonded with a bonding member (not shown). The fixing frame 121C may be formed integrally with the support plate 101. The fixing frame 121C may be made of a metal material and may be bonded to the support plate 101. The fixing frame 121C may include a columnar lower frame 25 and a plate-shaped upper frame 26. The columnar shape may be a circular or polygonal column, and the plate shape may have a circular or polygonal top view. The upper frame 26 may have a diameter D13 or width greater than the diameter or width of the lower frame 25, and may have a diameter D13 or width greater than the length D2 (See FIG. 4b) of the region in the first direction X where the connection members 141 and 142 are disposed. The fixing member 120C may be formed of a molding portion 122C without the fixing frame 121C. That is, the diameter D13 is longer than the length of the region vertically overlapping the intermediate wire portions 42 of the first and second connection members 141 and 142 with respect to the upper surface of the circuit board 110, or has a length greater than the length between both ends of the intermediate wire portions 42 of the first and second connection members 141 and 142 in the first direction X.

The molding portion 122C is disposed on the periphery of the lower frame 25 of the fixing member 120C and the surface and periphery of the upper frame 26, and is caught by the catch structure between the lower frame 25 and the upper frame 26, so that detachment or separation may be prevented by the structure or shape of the fixing frame 121C. The lower portion of the molding portion 122C may have a cylindrical or polygonal cylindrical shape, and the upper surface may have a convex curved surface or a flat surface. The upper end of the molding portion 122C may be positioned higher than the upper height H2 of the fixing frame 121C and higher than the upper surface height of the circuit board 110 based on the upper surface of the support plate 101. The upper end of the molding portion 122C may have a height higher than the highest point of the first and second connection members 141 and 142 based on the upper surface of the support plate 101.

A portion of the molding portion 122C may extend to the upper surface of the circuit board 110. A portion of the molding portion 122C may extend on at least one of the first end portion 41 and the second end portion 43 of the first connection member 141. A portion of the molding portion 122C may extend on at least one of the first end portion 41 and the second end portion 43 of the second connection member 142. A portion of the molding portion 122C may extend on at least one of the first and second bonding pads 134 and 135. A portion of the molding portion 122C may extend on at least one of the first and second pads 111 and 112. The region where the molding portion 122C extends may include at least one or two or more of the aforementioned components, such as the first end portion 41, the second end portion 43, the bonding pads 134 and 135, or the pads 111 and 112.

Each of the first and second connection members 141 and 142 is connected between the bonding pads 134 and 135 of the light source portion 130 and the pads 111 and 112 of the circuit board 110, and extends on the fixing frame 121C. The molding portion 122C is formed inside the recess 106 and on the surface of the fixing frame 121C, and surrounds a portion of the first and second connection members 141 and 142, for example, a portion of the intermediate wire portion 42. Based on the upper surface of the support plate 101, the molding portion 122C may vertically overlap the recess 106, protrude on the highest point of the connection members 141 and 142, and support and fix a portion of the connection members 141 and 142, i.e., the intermediate wire portion 42.

A portion of the molding portion 122C may contact the inner surface of the recess 106 of the circuit board 110 and/or the upper surface of the circuit board 110. A portion of the molding portion 122C may contact the other side of the light source portion 130 and the upper surface of the support plate 101. A portion of the molding portion 122C may contact the surface of the adhesive member 138.

The fixing member 120C fixes and supports the connection members 141 and 142 in the area between the circuit board 110 and the light source portion 110, thereby preventing movement of the connection members 141 and 142 and preventing a short circuit between the connection members 141 and 142 and the support plate 101.

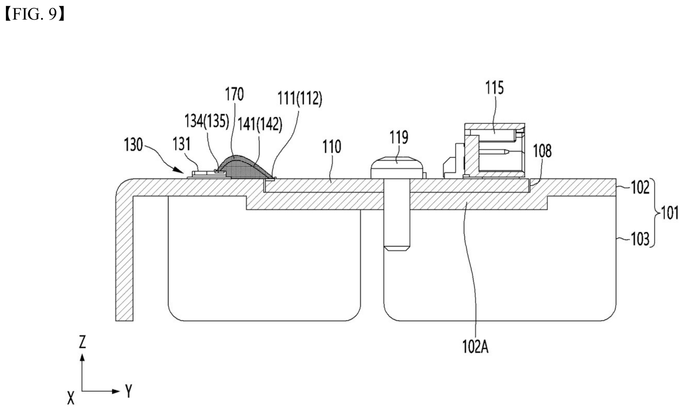

FIGS. 9 to 11 are drawings of a lighting device according to a second embodiment of the invention.

Referring to FIGS. 9 to 11, the lighting device may include a support plate 101, a circuit board 110, a light source portion 130, a connection member 141 and 142, and a molding portion 170. The configuration of the support plate 101, the circuit board 110, the light source portion 130, and the connection member 141 and 142 may include the configuration and description of the first embodiment disclosed above. The molding portion 170 includes a resin material, and may include a transparent resin material, a translucent resin material, or a reflective resin material. The material of the molding portion 170 may include a resin material such as silicone or epoxy, an acrylate, a urethane, a polyolefin, a UV resin, or an insulating material, or may be a selective mixture thereof.

The support plate 101 has a concave receiving portion 108 on the upper portion 102, into which the lower portion of the circuit board 110 may be inserted. The stepped bottom portion 102A of the upper portion 102 of the support plate 101 is the bottom of the receiving portion 108 and may be positioned lower than the upper surface of the upper portion 102. The lower surface of the circuit board 110 within the receiving portion 108 may be adhered to the bottom of the receiving portion 108 using an adhesive film 118. Since the circuit board 110 is positioned within the receiving portion 108, the height of the upper surface of the circuit board 110 may be positioned lower with respect to the upper surface of the support plate 101 on which the light source portion 130 is positioned. That is, the upper surface of the circuit board 110 may be positioned on a horizontal straight line extending from the upper surface of the light source portion 130 with respect to the upper surface of the support plate 101 on which the light source portion 130 is positioned, or may be positioned lower than the horizontal straight line extending from the upper surface of the light source portion 130. In this way, since the upper surface of the circuit board 110 is positioned low, the position of the highest point of the connection members 141 and 142 may be lower than the position of the highest point of the connection members 141 and 142 of FIG. 2.

The molding portion 170 may be positioned on the other side region of the light source portion 130 and one side region of the circuit board 110. The molding portion 170 may be disposed on the other side of the light source portion 130, one side of the circuit board 110, and the region between the light source portion 130 and the circuit board 110. The other side of the light source portion 130 is a region adjacent to the circuit board 110 among the areas of the light source portion 130 and is a region that does not overlap with the light emitting device 131 in the vertical direction Z. The other side of the light source portion 130 is a region that vertically overlaps with the bonding pads 134 and 135 of the light source portion 130. The one side region of the circuit board 110 may be a region adjacent to the light source portion 130 and may vertically overlap with the pads 111 and 112.

The molding portion 170 may cover the entire surface of the connection member 141 and 142. For example, the molding portion 170 may cover the first end portion 41, the intermediate wire portion 42, and the second end portion 43 of the connection member 141 and 142. The molding portion 170 may have a convex curved surface on the region between the light source portion 130 and the circuit board 110. The highest point Zy1 of the molding portion 170 may be positioned higher than the highest point of each of the connection members 141 and 142, and for example, the distanceG11 between the highest point Zy1 of the molding portion 170 and the highest point of the connection member 141 and 142 may be spaced apart by 0.1 mm or more, for example, in the range of 0.1 mm to 0.3 mm. Accordingly, the molding portion 170 protects the surfaces of the connection members 141 and 142 and prevents oxidation of the connection members 141 and 142. The height H12 of the highest point Zy1 of the molding portion 170 may be 1.2 mm or more, for example, in the range of 1.2 mm to 2 mm or 1.2 mm to 1.5 mm, relative to the upper surface of the circuit board 110.

The molding portion 170 may extend from the other side region of the light source portion 130 to one side region of the circuit board 110. The top-view shape of the molding portion 170 may include a polygonal shape such as a square, a circular or oval shape, or a shape with straight and curved outlines. The molding portion 170 has an outer wall 170A, and the outer wall 170A may be formed in a ring shape along the light source portion 130, the surface of the adhesive member 138, the upper surface of the support plate 101, and the upper surface of the circuit board 110. As shown in FIG. 10, a portion 170B of the molding portion 170 may extend to the receiving part 108 in which the circuit board 110 is received. A portion 170B of the molding portion 170 may adhere one side of the circuit board 110 to the receiving portion 108.

The outer surface of the outer wall 170A may be provided as an outer line of the molding portion 170. The shape of the outer wall 170A may include a polygonal shape, a circular shape, an elliptical shape, a shape having a convex curve and a concave curve, or a shape having the curve and a straight line. The outer wall 170A may be in contact with the upper surface of the resin member 132 of the light source portion 130 and the upper surface of the protective layer 110B of the circuit board 110. The outer wall 170A may be formed of the same material as the material of the molding portion 170. The outer wall 170A is arranged around the region of the molding portion 170 and may have a dam shape. The outer surface of the outer wall 170A may be a vertical surface, a surface having an incline, or a curved surface. The outer wall 170A may prevent liquid resin from overflowing during the manufacturing process of the molding portion 170. Accordingly, the problem of the molding portion 170 penetrating the surface of the light emitting device 131 through the outer wall 170A on the upper surface of the light source portion 130 may be prevented. In addition, since the outer line of the molding portion 170 is formed by the outer wall 170A, the amount of resin liquid dispensed for the molding portion 170 may be reduced.

On the light source portion 130, the outer surface of the outer wall 170A may be spaced apart from the light emitting device 131. On the upper surface of the light source portion 130, the outer wall 170A may be positioned between the light emitting device 131 and the bonding pads 134 and 135, and may be positioned closer to the bonding pads 134 and 135 than to the light emitting device 131.

The upper end of the outer wall 170A positioned on the light source portion 130 may be equal to or lower than the highest point of the connection member 141 and 142, and the upper end height H13 of the outer wall 170A positioned on the light source portion 130 may be 0.9 mm or more, for example, in the range of 0.9 mm to 1.30 mm, based on the upper surface of the circuit board 110. The height H11 of the highest point of the connection member 141 and 142 may be 1 mm or more, for example, in the range of 1 mm to 1.2 mm, based on the upper surface of the circuit board 110. The distance G12 between the horizontal straight line passing through the upper end of the outer wall 170A positioned on the light source portion 130 and the horizontal straight line passing through the highest point of the connection member 141 and 142 may be equal to or less than the distance G11. By storing the circuit board 110 in the receiving portion 108 of the support plate 101, the upper surface of the circuit board 110 may be lowered relative to the upper surface of the light source portion 130, and the highest point of the connection member 141 and 142 may also be lowered. Accordingly, the highest point Zy1 of the molding portion 170 may be lowered, thereby not affecting the distribution of the beam angle Q1 of the light emitting device 131.

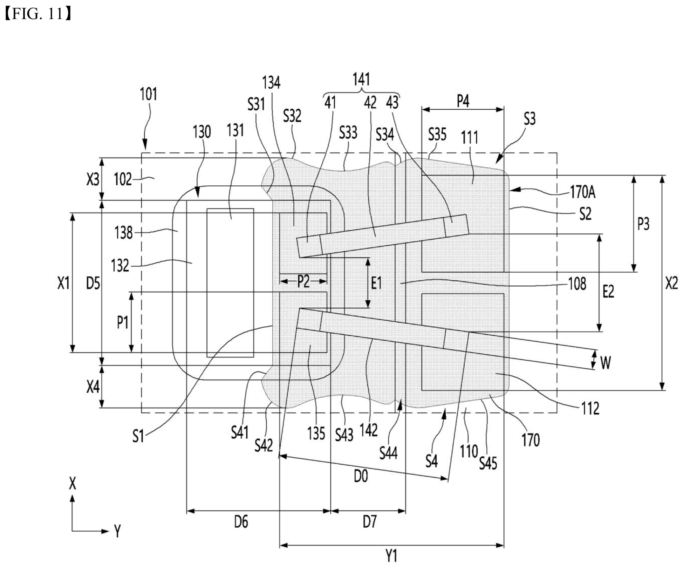

As illustrated in FIG. 11, the molding portion 170 may be disposed on the bonding pads 134 and 135 of the light source portion 130 and the pads 111 and 112 of the circuit board 110. The molding portion 170 seals the surfaces of the bonding pads 134 and 135 and the pads 111 and 112, and can suppress a decrease in the bonding force between the first and second end portions 41 and 43 of the connection members 141 and 142 and the bonding pads 134 and 135 or the pads 111 and 112.

The minimum distance E1 between the first end portions 41 of the first and second connection members 141 and 142 may be less than or equal to the minimum gap E2 between the second end portions 43 of the first and second connection members 141 and 142. For example, the minimum distances E1 and E2 may satisfy the condition: E1 ≤ E2, and preferably, E1 < E2. This can increase the area of the first and second pads 111 and 112 on the circuit board 110, and may also increase the distance between the first and second pads 111 and 112 more than the distance between the first and second bonding pads 134 and 135. Accordingly, within the minimum spacing E1 and E2, E2 may be more than 1 time and less than 2 times the distance E1. If the minimum distance E2 is larger than the above range, the material of the connection members 141 and 142 may be wasted, and each end 41 and 43 may tilt due to the spacing between the connection members 141 and 142, and thus, the bonding fixation of the equipment bonding each end 41 and 43 may become difficult. The minimum gap E1 between the first end portions 41 of the first and second connection members 141 and 142 may be larger than the width W of the connection members 141 and 142, for example, may be 1 mm or more or in the range of 1 mm to 6 mm.

The internal angle between two imaginary straight lines extending in the longitudinal direction of the first and second connection members 141 and 142 may be 1 degree or more, for example, 1 to 90 degrees or 10 to 60 degrees. If the internal angle is smaller than the above range, the bonding area of the molding portion on the circuit board 110 may be reduced. This allows the second end portion 43 of the connection member 141 and 142 to be supported by the molding portion having a larger area on the circuit board 110.

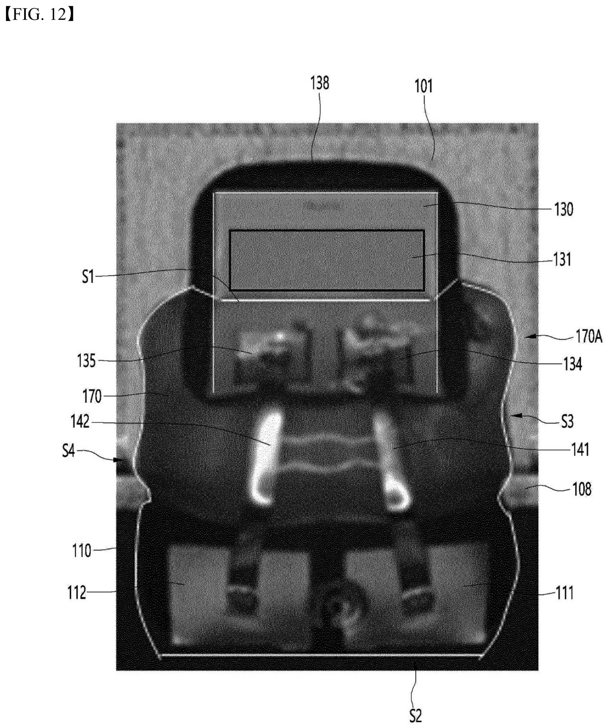

Referring to FIGS. 11 and 12, the outer line of the molding portion 170 is the outer line of the outer wall 170A and may include first to fourth side portions S1, S2, S3, and S4. The first side portion S1 extends in a first direction X on the light source 130, the second side portion S2 extends in the first direction X on the circuit board 110, and the third side portion S3 and the fourth side portion S4 may extend in a second direction Y from both ends of the first side portion S1 and the second side portion S2. The first and second side portions S1 and S2 are lines on both sides of the molding portion 170 in the first direction X, and the third and fourth side portions S3 and S4 are lines on both sides of the molding portion 170 in the second direction Y. A region between the first side portion S1 and the third side portion S3 or a region on one side of the third side portion S3 may have a convex curved region. The region between the first side portion S1 and the fourth side portion S4 or one side region of the fourth side portion S4 may have a convex curved region.

The first side portion S1 may extend in a straight line along the first direction X on the light source portion 130, and the second side portion S2 may extend in a straight line along the first direction X on the circuit board 110. Since the first side portion S1 is spaced apart from the light emitting device 131 in a straight line along the first direction X on the light source portion 130, the problem of a portion of the molding portion 170 penetrating into the surface of the light emitting device 131 may be prevented, and the problem of affecting the distribution of the beam angle may be blocked.

The maximum length of the third and fourth side portions S3 and S4 of the molding portion 170 in the first direction X may be greater than the distance X1 between the both sides of the region having the first and second bonding pads 134 and 135 in the first direction X and may be greater than the distance X2 between the both sides of the region having the first and second pads 111 and 112 in the first direction X. The maximum length of the third and fourth side portions S3 and S4 of the molding portion 170 on both sides of the light source portion 130 in the first direction X may be greater than the length D5 of the light source portion 130 in the first direction X. The linear distance D0 between the outer ends of the first and second end portions 41 and 43 of each of the connection members 141 and 142 may be smaller than the distance between the first and second side portions S1 and S2 of the molding portion 170 in the second direction Y.

The third side portion S3 of the molding portion 170 may include a portion having a convex curved surface on the outer side and a portion having a concave curved surface. In detail, the third side portion S3 may include a 3-1 portion S31 extending from one end of the first side portion S1 onto the adhesive member 138, a 3-2 portion S32 extending from the 3-1 portion S31 with a convex curved surface outward, a 3-3 portion S33 extending from the 3-2 portion S32 with a concave curved surface, a 3-4 portion S34 connected between the 3-3 portion S33 and the 3-5 portion S35 and disposed on the receiving portion 108, and a convex 3-5 portion S35 extending from the 3-4 portion S34 to one end of the second side portion S2. Here, a boundary area between the 3-1 portion S31 and the 3-2 portion S32 is provided with a convex curved surface. The third-third portion S33 of the molding portion 170 is recessed into the area between the circuit board 110 and the light source portion 130, and the 3-4 portion S34 may be concave toward the inside or the bottom of the receiving portion 108 due to the stepped area of the receiving portion 108.

The fourth side portion S4 of the molding portion 170 may include a portion having a convex curved surface on the outside and a portion having a concave curved surface. In detail, the fourth side portion S4 may include a 4-1 portion S41 extending from the other end of the first side portion S1 onto the adhesive member 138, a 4-2 portion S42 extending from the 4-1 portion S41 with a convex curved surface outward, a 4-3 portion S43 extending from the 4-2 portion S42 with a concave curved surface, a 4-4 portion S44 connected between the 4-3 portion S43 and the 4-5 portion S45 and disposed on the receiving portion 108, and a convex 4-5 portion S45 extending from the 4-4 portion S44 to the other end of the second side portion S2. Here, a boundary region between the 4-1 portion S41 and the 4-2 portion S42 is provided with a convex curved surface. The 4-3 portion S43 of the molding portion 170 is recessed into the area between the circuit board 110 and the light source portion 130, and the 4-4 portion S44 may be recessed inward or toward the bottom of the receiving portion 108 due to the stepped area of the receiving portion 108.

The 3-2 portion S32 of the third side portion S3 of the molding portion 170 and the 4-2 portion S42 of the fourth side portion S4 may protrude in a convex shape outward from the straight line passing through the first side portion S1. The distance between the 3-2 portion S32 of the third side portion S3 of the molding portion 170 and the 4-2 portion S42 of the fourth side portion S4 may be greater than the length D5 of the light source portion 130 in the first direction X. The 3-2 portion S32 of the third side portion S3 of the molding portion 170 and the 4-2 portion S42 of the fourth side portion S4 may cover the adhesive member 138 adhered to the outside of the light source portion 130, thereby preventing movement of the light source portion 130. The distance X3 between the outer surface of the 3-2 portion S32 of the third side portion S3 of the molding portion 170 and the light source portion 130 may be at least 0.3 mm or more, for example, in the range of 0.3 mm to 0.5 mm. The distance X4 between the outer surface of the 4-2 portion S42 of the fourth side portion S4 of the molding portion 170 and the light source portion 130 may be at least 0.3 mm or more, for example, in the range of 0.3 mm to 0.5 mm.

The distance between the first side portion S1 of the molding portion 170 and the light emitting device 131 on the light source portion 130 may be 0 or more and 0.2 mm or less. The first side portion S1 of the molding portion 170 may cover the first and second bonding pads 134 and 135 and may not be in contact with the wavelength conversion layer 31 (See FIG. 10). The distance between the second side portion S2 of the molding portion 170 and the first and second pads 111 and 112 on the circuit board 110 may be 0 or more and 0.2 mm or less. The second side portion S2 of the molding portion 170 may cover the first and second pads 111 and 112.

The maximum length of the third and fourth side portions S3 and S4 of the molding portion 170 in the second direction Y may be greater than the distance Y1 between the two sides of the region having the first and second bonding pads 134 and 135 and the first and second pads 111 and 112 in the second direction Y, so that the molding portion 170 may seal the first and second bonding pads 134 and 135 and the first and second pads 111 and 112. The minimum length of the molding portion 170 in the first direction X extending along the first side portion S1 of the molding portion 170 on the light source portion 130 may be greater than the length D5 of the light source portion 130 in the first direction X. The minimum length in the first direction X of the molding portion 170 extending along the second side portion S2 of the molding portion 170 on the circuit board 140 may be greater than the distance X2 between the two sides of the area having the first and second pads 111 and 112.

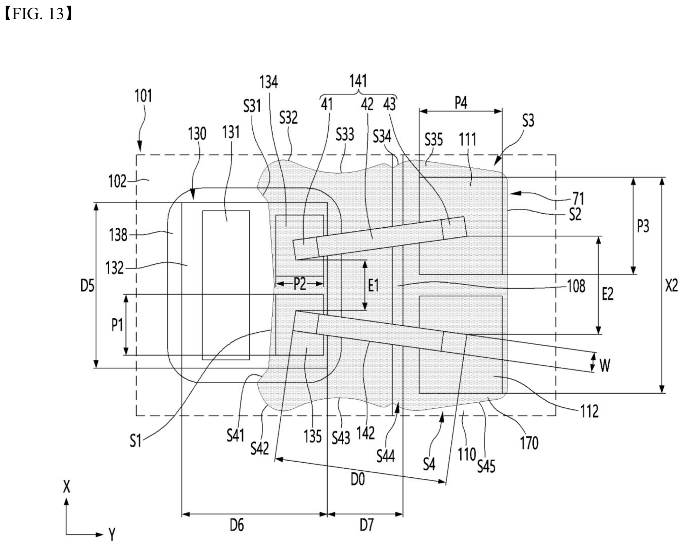

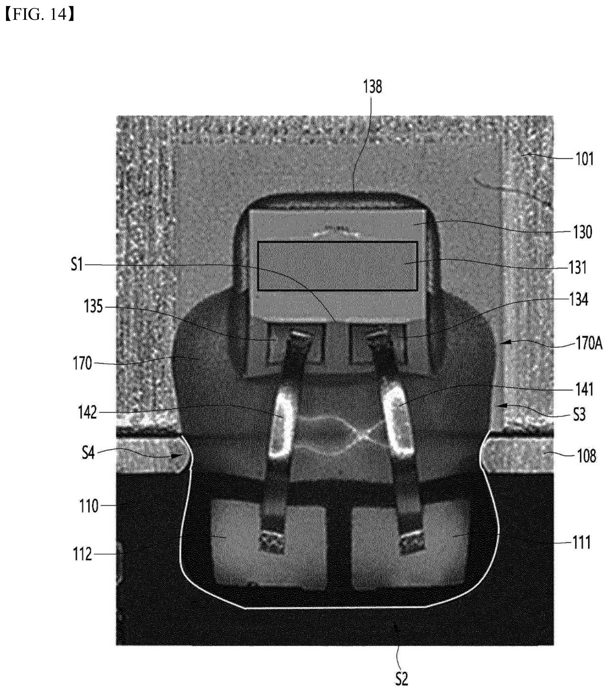

As another example, as shown in FIGS. 13 and 14, the first side portion S1 of the molding portion 170 may have a concave shape toward the area between the first and second bonding pads 134 and 135 on the light source portion 130. That is, as the first side portion S1 moves toward the first and second bonding pads 134 and 135, the distance from the light emitting device 131 may gradually increase. The first side portion S1 may be a concave curve or may extend in a slanted shape toward the 3-1 portion S31 and the 4-1 portion S41 based on the region between the first and second bonding pads 134 and 135. Accordingly, since the molding portion 170 covering the first and second bonding pads 134 and 135 is arranged along the first side portion S1, the problem of the molding portion 170 extending to the surface of the light emitting device 131 may be prevented.

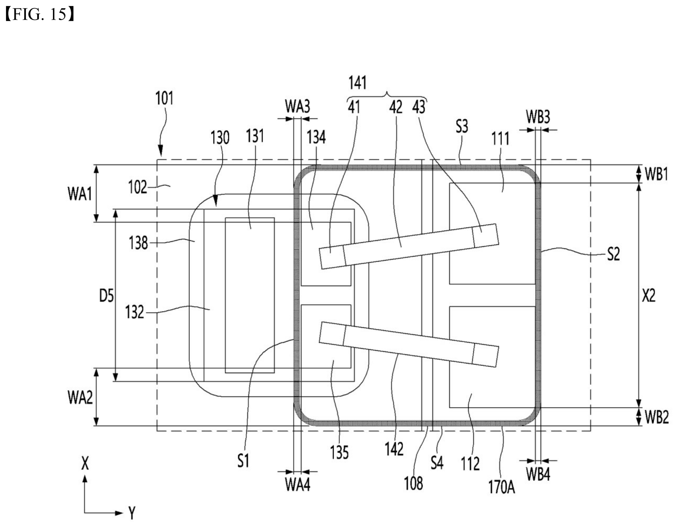

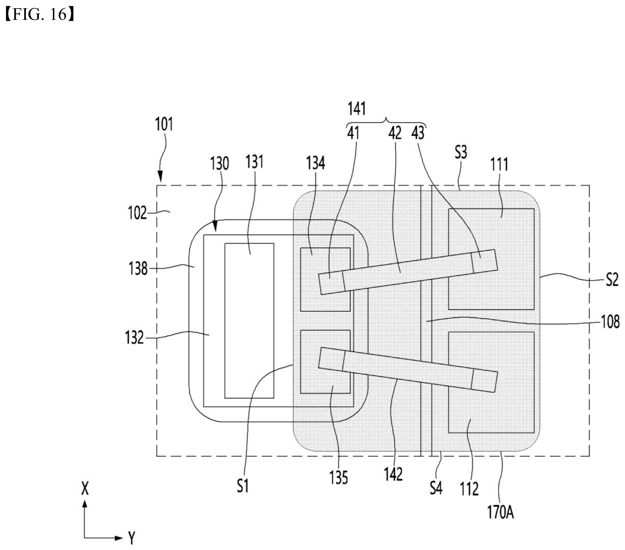

FIG. 15 and FIG. 16 are schematic drawings showing a process for manufacturing the molding portion. As shown in FIG. 15, the outer wall 170A has first and second side portions S1 and S2 extending in the first direction X along the outer sides of the first and second bonding pads 134 and 135 of the light source portion 130 and the second direction Y of the first and second pads 111 and 112, and may have third and fourth side portions S3 and S4 extending in the second direction Y from both ends of the first and second side portions S1 and S2. The top view shape of the outer wall 170A may be a polygonal shape, and as other examples, may be an elliptical shape or a circular shape, a polygonal shape with curved corners, or a shape having straight lines and curved lines. In addition, the shape of the outer wall 170A may be the outer line shape of the molding portion 170 of FIGS. 11 to 14.

On the light source portion 130, the outer surface of the outer wall 170A or the outer surface of the first side portion S1 may be spaced apart from the outer ends of the first and second bonding pads 134 and 135 by a distance WA3 and WA4 ranging from 0 mm to 0.2 mm. On the circuit board 110, the outer surface of the outer wall 170A or the outer surface of the second side portion S2 may be spaced apart from the outer ends of the first and second pads 111 and 112 by a distance WB3 and WB4 ranging from 0 mm to 0.2 mm. On the light source portion 130, both sides of the outer wall 170A or the outer surfaces of the third and fourth side portions S3 and S4 may be spaced apart from the outer ends of the first and second bonding pads 134 and 135 by a distance WA1 and WA2 ranging from 0 mm to 0.2 mm. On the circuit board 110, both sides of the outer wall 170A or the outer surfaces of the third and fourth sides S3 and S4 may be spaced apart from the outer ends of the first and second pads 111 and 112 by a distance WB1 and WB2 ranging from 0 mm to 0.2 mm. Since the distance X2 between the two sides of the region having the first and second pads 111 and 112 in the first direction X is provided to be greater than the length D5 of the light source portion 130 in the first direction X, the separation distance between the third and fourth side portions S3 and S4 on the circuit board 110 may be provided to be greater than the distance X2 between the both sides of the region having the first and second pads 111 and 112 in the first direction X.

As shown in FIGS. 15 and 16, when the outer wall 170A is cured, a molding liquid, i.e., a liquid resin, is dispensed into the inner side of the outer wall 170A and cured. The molding portion 170 is filled with the inner side of the outer wall 170A, and the liquid resin may not flow out to the outer side of the outer wall 170A due to the outer wall 170A. Furthermore, since the outer wall 170A forms the outer line of the molding portion 170, the amount of resin dispensed for the molding portion 170 may be reduced. Furthermore, the corner portions of the outer wall 170A may be curved, thereby reducing the amount of resin dispensed during the formation of the molding portion 170. Specifically, the corner portions between the first side portion S1 and the third and fourth side portions S3 and S4, and the corner portions between the second side portion S2 and the third and fourth side portions S3 and S4 of the outer wall 170A may be curved. The molding portion 170 may be made of the same material as the outer wall 170A, in which case the boundary surface between the molding portion 170 and the outer wall 170A may be removed.

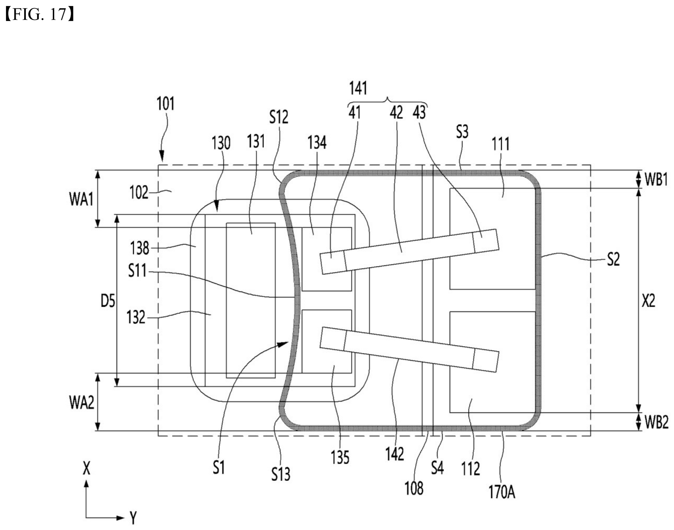

As shown in FIG. 17, the first side portion S1 of the outer wall 170A may be deformed. The first side portion S1 may include a 1-1 portion S11 having a concave curve shape on the light source portion 130, a 1-2 portion S12 extending in a convex curve from one end of the 1-1 portion S11 to one end of the third side portion S3, and a 1-3 portion S13 extending in a convex curve from the other end of the 1-1 portion S11 to one end of the fourth side portion S4. The closer the 1-1 portion S11 is to the region between the first and second bonding pads 134 and 135 at both ends of the 1-1 portion S11, the farther away it is from the light emitting device 131. Since the distance between the 1-1 portion S11 and the upper surface of the light emitting device 131 becomes farther from both sides of the light source section 130 toward the center, interference with the beam angle distribution of the light emitting device 131 may be suppressed and the amount of resin liquid may be reduced. In addition, the 1-2 portion S12 and the 1-3 portion S13 have a convex curved shape from both sides of the light source section 130 toward both sides of the light source section 130, so that loss of light emitted to both sides of the light source section 130 may be reduced. When the resin liquid is dispensed and hardened inside the outer wall 170A to form a molding section, the 1-1 portion S11, the 1-2 portion S12, and the 1-3 portion S13 may be provided as the lower line of the convex curved surface in the molding section.

In a lighting device according to an embodiment of the invention, as shown in FIGS. 18 and 19, light emitted from a light source portion 130 may be extracted through a light guide module 500 made of a transparent material. The lighting device disclosed above may be defined as a light source module.

As shown in FIGS. 18 and 19, the light guide module 500 includes a transparent plate 510 and a light guide portion 520. The transparent plate 510 may be made of a transparent plastic material, and the light guide portion 520 may protrude from the transparent plate 510 and be made of a transparent plastic material. The transparent plastic material may include PC or PMMA. The transparent plate 510 and the light guide portion 520 may be made of the same material. The transparent plate 510 and the light guide portion 520 may be integrally formed of a transparent material.

The transparent plate 510 aligns the positions between the light source portion 130 and the light guide portion 520 and may be coupled to the support plate 101. In addition, the transparent plate 510 can cover the upper circumference of the light source portion 130 so that light emitted from the light source portion 130 can effectively be incident on the light guide portion 520. The lower surface or upper surface of the transparent plate 510 may be arranged parallel to the upper surface of the support plate 101. The transparent plate 510 may be spaced a predetermined distance from the upper surface of the support plate 101 and may be located higher than the height of the uppermost end of the fixing member 120 of FIG. 1, for example, 2.5 mm or more, for example, in the range of 2.5 mm to 7 mm.

The light guide portion 520 is provided in a columnar shape and can include, for example, a circular columnar or polygonal columnar shape. The light guide portion 520 may have a shape with a narrow lower area and a wide upper area depending on the directional distribution of the light source portion 130. The beam angle of the light source portion 130 may be 70 degrees or more, for example, in the range of 70 degrees to 150 degrees. The light guide portion 520 may overlap with the light source portion 130 in a vertical direction. The light guide portion 520 emits the point light of the light source portion 130 as surface light. The light guide portion 520 may have a lower surface area or/and an upper surface area that is larger than the upper surface area of the light source portion 130. The light guide portion 520 may have a diameter or width greater than the length D5 (See FIG. 10) of one side of the light source portion 130, for example, at least 1.5 times the length of one side of the light source portion 130, and preferably at least 5 mm, for example, in the range of 5 mm to 10 mm. If the diameter or width of the light guide portion 520 is smaller than the above range, the amount of incident light may be reduced, and if it is larger than the above range, the luminous intensity or luminous intensity distribution may be degraded.

The transparent plate 510 includes a first support protrusion 531 and a second support protrusion 535 at the bottom. The first support protrusion 531 may be positioned on both outer lower sides of the transparent plate 510, and the second support protrusion 535 may be positioned on both inner lower sides. Here, the inner side may be the direction of the circuit board 110 arranged at the center of the support plate 101. The transparent plate 510 may be coupled to the support plate 101 by a fastening means through the first support protrusion 531 and the second support protrusion 535. A coupling portion 535A coupled to the first and second support protrusions 531 and 535 may be arranged on the upper surface of the transparent plate 510, or a washer or nut may be coupled.

This light guide module 500 may extract light, for example, white light, emitted through the light source 130 of the lighting device 1000 to the outside. In addition, the light guide portion 520 is arranged in the direction in which the highest luminous intensity is emitted from the light source 130, and since the light is incident, it may be emitted to the outside without any light loss. Such a light guide module may be applied to the lighting device disclosed in the first and second embodiments.

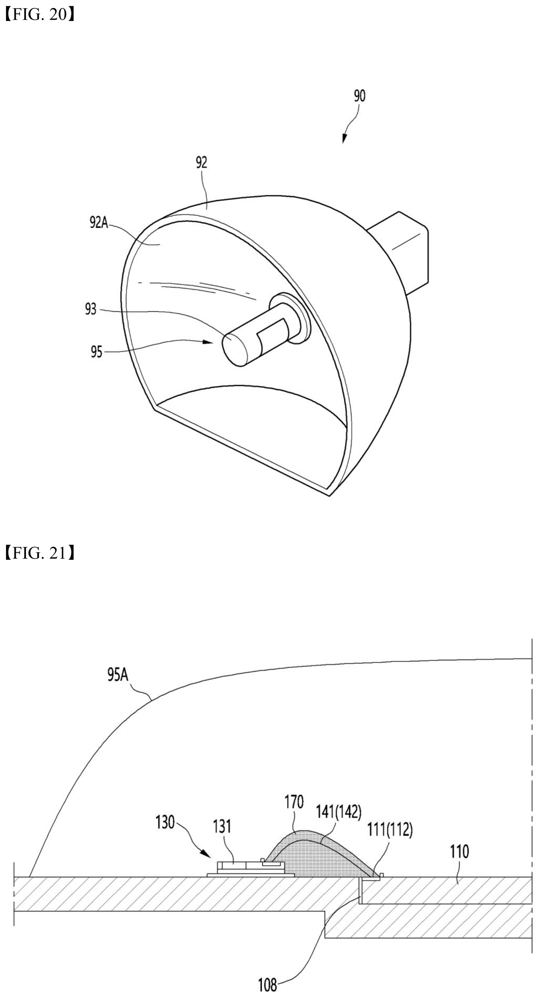

Referring to FIG. 20, a vehicle headlamp 90 having a lighting device according to an embodiment includes a light source module 93 and a housing 92. The light source module 93 is positioned within the housing 92 to radiate light, and the radiated light may be reflected in an emission direction through an inner surface 92A of the housing 92. The housing 92 has a cavity 95 therein, and the cavity 95 is a region open in the emission direction or on one side, and the light source module 93 may be coupled therein. The light source module 93 may include the lighting device disclosed above. The shape of the cavity 95 may be hemispherical, semi-elliptical, circular, or elliptical when viewed from the emission direction or the opening direction.

The housing 92 may include a metallic or non-metallic material, and the non-metallic material may include a plastic material. The housing 92 may be a reflector of a headlamp. The inner surface 92A of the housing 92 or the inner surface 92A of the cavity 95 may be coated with a highly reflective material or may include a reflective layer made of an anti-reflection (AR) material. For example, the highly reflective material may include at least one metal, such as Al, Ag, or Au, and the anti-reflection material may include at least one of MgF2, Al2O3, SiO, SiO2, TiO2+ZrO2, TiO2, or ZrO2. The reflective layer of the inner surface 92A may be a single layer or multiple layers. Since the cavity 95 is provided with a reflective material around its periphery, it may function as a reflective cup.

The headlamp 90 may include an inner lens and/or an outer lens that project light emitted through the housing 92. The light distribution pattern of the light emitted from the light source module 93 may be adjusted depending on the shape of the inner lens or the number of light source portions. The light source module 93 selectively radiates light of a high beam distribution pattern and a low beam distribution pattern, and the high beam distribution pattern or the low beam distribution pattern may be automatically turned on and off depending on the driving mode or driving situation. The inner surface 92A of the housing 92 may include a partially domed or partially elliptical paraboloid. The inner surface 92A may have a plurality of facets. The facets may be free-form, flat, and/or curved (e.g., concave or convex) members. In some examples, a single facet may have a free-form portion, a flat portion, and/or a curved portion (e.g., any combination thereof). In some embodiments, the facets (or at least the inwardly facing surfaces on the facets) may be at least approximated, or otherwise defined by algebraic equations. For example, the shape or inwardly facing surfaces of the facets may be expressed by one or more fifth-order algebraic equations (although other equations of any order are also possible). In at least one exemplary embodiment, the surfaces (or, for example, coatings) of the facets have high reflectivity (e.g., greater than 80%). Non-limiting examples of the facets and/or coatings on the facets include aluminum and silver, although other reflective materials may be used. The inner surface 92A of the housing 92 is spaced laterally from the light source module 93, and light emitted from the light source module 93 may be reflected by the inner surface 92A and focused onto the exit side of the housing 92, and irradiated with high or low beams.

The exterior of the housing 92 may include various features and accessories for mounting or connecting the headlamp 90 to the interior of the vehicle, and may have an electrical interface, such as a socket, for connecting power and/or signals. The housing 92 and cavity 95 described above are merely examples and may be modified into various shapes. The housing 92 according to an embodiment may function as a reflector for the left/right headlamps 90.

Another example of a lamp is an example in which a reflector is applied to a lighting device, as shown in FIG. 21. The lighting device may apply the lighting device disclosed in the embodiment or another example. As shown in FIG. 21, the support plate 101 may include a concave receiving portion 108 on the upper portion. Accordingly, the stepped bottom portion 102A of the upper portion 102 of the support plate 101 may be positioned lower than the upper surface of the upper portion 102. The receiving portion 108 may be provided in a size such that the circuit board 110 may be inserted therein. The depth of the receiving portion 108 may be 0.5 times or more, for example, 0.5 to 1.5 times the thickness of the circuit board 110. If the depth of the receiving portion 108 is greater than the above range, rigidity may be reduced in the stepped region of the upper portion 102, and if it is less than the above range, the effect of lowering the high point height of the wire may be reduced.

The lower end of the reflector 95A may be arranged on the upper portion 102 of the support plate 101. The lower end of the reflector 95A may be arranged in an area adjacent to the light source portion 130 arranged on the support plate 101. The lower end of the reflector 95A may be provided in a form that surrounds at least three sides and the upper surface of the light source portion 130. The region between the upper end of the reflector 95A and the upper surface of the support plate 101 may be a region where light is emitted. The interior of the reflector 95A, i.e., the region between the reflector 95A and the upper portion of the support plate 101, may be an open region where light is mixed.

The vertical distance between the upper end of the reflector 95A and the upper surface of the support plate 101 may be greater than the distance between the upper surface of the light source portion 130 and the point where an imaginary straight line perpendicular to the upper surface of the light source portion 130 intersects the reflector 95A. Accordingly, the reflector 95A may radiate light emitted from the light source portion 130 laterally. Here, the lateral direction is a direction moving away from a straight line perpendicular to the light source portion 130 and is a direction in which the light reflected by the reflector 95A and the light emitted from the light source portion 130 are emitted. As another example, the lower end of the reflector 95A may be disposed on the circuit board 110. As another example, the lower end of the reflector 95A may be disposed on the circuit board 110 and the upper portion 102 of the support plate 101. Depending on the position of the reflector 95A, the direction in which the light is emitted may vary, and for example, the direction in which the light is emitted between the support plate 101 and the reflector 95A may be at least one direction among directions orthogonal to an imaginary straight line perpendicular to the light source portion 130.

Features, structures, effects, etc. described in the above embodiments are included in at least one embodiment of the invention, and are not necessarily limited to only one embodiment. Furthermore, features, structures, effects, etc. illustrated in each embodiment may be combined or modified for other embodiments by those of ordinary skill in the art to which the embodiments belong. Accordingly, the contents related to such combinations and modifications should be interpreted as being included in the scope of the invention. In addition, although the embodiments have been mainly described above, this is only an example and does not limit the present invention, and one of ordinary skill in the field to which the present invention belongs will appreciate that various modifications and applications not illustrated above may be possible without departing from the essential characteristics of the present embodiment. For example, each component specifically shown in the embodiment may be implemented by modification. And differences related to such modifications and applications should be construed as being included in the scope of the invention defined in the appended claims.

## Claims

1. A lighting device comprising:
a support plate having a concave receiving portion on an upper portion thereof;
a circuit board disposed on the receiving portion of the support plate;
a plurality of pads disposed on one side of the circuit board;
a light source portion disposed on the support plate and including a light emitting device and a plurality of bonding pads;
a plurality of connection members respectively connecting the plurality of pads to the plurality of bonding pads; and
a molding portion covering the plurality of connection members, the plurality of pads, and the plurality of bonding pads,
wherein an outer line of the molding portion has first to fourth side portions,
wherein the first side portion of the molding portion extends in a first direction along a region between an upper surface of the light emitting device and upper surfaces of the plurality of bonding pads of the light source portion,
wherein the second side portion of the molding portion extends in the first direction along an outer side of the plurality of pads on the circuit board, and
wherein the third and fourth side portions of the molding portion extend from both ends of the first and second side portions in a second direction perpendicular to the first direction and have a convex curve and a concave curve.

2. The lighting device of claim 1,
wherein the plurality of pads includes a first pad and a second pad adjacent to the light source portion,
wherein the plurality of bonding pads includes a first bonding pad and a second bonding pad adjacent to the circuit board,
wherein the plurality of connection members includes a first connection member connecting the first pad and the first bonding pad, and a second connection member connecting the second pad and the second bonding pad, and
wherein a highest point of the molding portion is disposed higher than highest points of the first and second connection members with respect to an upper surface of the circuit board.

3. The lighting device of claim 2,
wherein the highest point of the molding portion is disposed on a region between the circuit board and the light source portion.

4. The lighting device of claim 3,
wherein highest points of the first and second connection members are disposed on a region between the circuit board and the light source portion.

5. The lighting device of any one of claims 1 to 4, further comprising:
an adhesive member disposed between the light source portion and the support plate,
wherein the third and fourth side portions of the molding portion protrude further outward than the adhesive member disposed on both sides of the light source portion in the first direction.

6. The lighting device of claim 5,
wherein the first side portion of the molding portion has a straight shape or a concave shape along the plurality of bonding pads of the light source portion.

7. The lighting device of claim 7,
wherein a distance between the first side portion of the molding portion and the light emitting device gradually increases toward a region between the plurality of bonding pads on both sides of the light source portion in the first direction.

8. The lighting device of claim 6,
wherein one region of the third side portion and one region of the fourth side portion have convex curved portions on both sides of the light source portion.

9. The lighting device of any one of claims 2 to 4,
wherein each of the first and second connection members includes a first end bonded to the first and second bonding pads, a second end bonded to the first and second pads, and an intermediate wire portion connecting the first end and the second end, and
wherein a distance between the second ends of the first and second connection members is greater than a distance between the first ends thereof.

10. The lighting device of any one of claims 1 to 4,
wherein each of the plurality of connection members is a ribbon wire having a width greater than twice a thickness thereof.

11. A lamp comprising:
a lighting device emitting white light,
a light guide module or a reflector disposed on the lighting device,
wherein the lighting device is a lighting device according to any one of claims 1 to 4.
